# EUROPEAN PATENT SPECIFICATION

(11) **EP 2 821 460 B1**
(45) Date of publication and mention of the grant of the patent: **30.12.2020**
(21) Application number: 13755726.0
(22) Date of filing: 27.02.2013
(51) Int. Cl.: C09K 11/06, H01L 51/54, H05B 33/20, H01L 51/52

(54) **ORGANIC LIGHT EMITTING DIODE**
ORGANISCHE LICHTEMITTIERENDE DIODE
DIODE ÉLECTROLUMINESCENTE ORGANIQUE

(30) Priority: 27.02.2012 KR 20120019965
(43) Date of publication of application: 07.01.2015
(60) Divisional application: 20183186.4 / 3 741 827
(73) Proprietor: LG Chem, Ltd., Seoul 150-721 (KR)
(72) Inventor: HONG, Sung Kil, Daejeon 305-738 (KR); CHUN, Minseung, Daejeon 305-390 (KR); KIM, Kongkyeom, Daejeon 305-340 (KR); JANG, Jungi, Daejeon 305-340 (KR); KIM, Yun Hwan, Seoul 158-755 (KR); LEE, Dong Hoon, Daejeon 301-793 (KR)
(74) Representative: Hoffmann Eitle
(86) International application number: PCT/KR2013/001577
(87) International publication number: WO 2013/129836

(56) References cited:
- EP-A1- 2 031 670
- WO-A1-2008/123178
- WO-A1-2009/072587
- WO-A1-2009/081857
- WO-A1-2010/114021
- WO-A1-2011/040607
- JP-A- 2009 076 817
- JP-A- 2010 097 964
- KR-A- 20110 061 792

## Description

### [Technical Field]

This application claims priority from Korean Patent Application No. 10-2012-0019965 filed on February 27, 2012, in the KIPO.

The present invention relates to an organic light emitting diode. More particularly, the present invention relates to an organic light emitting diode having excellent characteristics comprising a low voltage, high efficiency, and a long life span, and a simple manufacturing process.

### [Background Art]

An organic light emitting phenomenon is an example of a conversion of current into visible rays by an internal process of a specific organic molecule. The organic light emitting phenomenon is based on the following principle. When an organic material layer is interposed between an anode and a cathode, if voltage is applied between two electrodes, electrons and holes are injected from the cathode and the anode to the organic material layer. The electrons and the holes injected into the organic material layer are recombined to form an exciton, and the exciton is reduced to a bottom state to emit light. An organic light emitting diode using the principle may be generally constituted by a cathode, an anode, and an organic material layer interposed therebetween, for example, an organic material layer comprising a hole injection layer, a hole transport layer, a light emitting layer, and an electron transport layer.

The material used in the organic light emitting diode is mostly a pure organic material or a complex compound where an organic material and metal form a complex, and may be classified into a hole injection material, a hole transport material, a light emitting material, an electron transport material, an electron injection material and the like according to the purpose. Herein, an organic material having a p-type property, that is, an organic material easily oxidized and electrochemically stable while the organic material is oxidized, is mainly used as the hole injection material or the hole transport material. Meanwhile, an organic material having an n-type property, that is, an organic material which is easily reduced and electrochemically stable while the organic material is reduced, is mainly used as the electron injection material or the electron transport material. A material having both p-type and n-type properties, that is, a material that is stable when the material is oxidized and reduced, is preferable as the light emitting layer material, and a material having high light emitting efficiency for converting the exciton into light when the exciton is formed is preferable.

In addition, it is preferable that the material used in the organic light emitting diode further have the following properties.

First, it is preferable that the material used in the organic light emitting diode have excellent thermal stability. This is because joule heat is generated by the movement of electric charges in the organic light emitting diode. Recently, NPB, which has mostly been used as the hole transport layer material, has a glass transition temperature of 100°C or lower, and thus there is a problem in that it is difficult to use NPB in an organic light emitting diode requiring high current.

Second, holes or electrons injected into the organic light emitting diode should be smoothly transported to a light emitting layer, and the injected holes and electrons should not be released out of the light emitting layer in order to obtain an organic light emitting diode that is capable of being driven at a low voltage and has high efficiency. To this end, a material used in the organic light emitting diode should have an appropriate band gap and HOMO or LUMO energy level. In the case of PEDOT:PSS currently used as a hole transport material in an organic light emitting diode manufactured by a solution coating method, since a LUMO energy level thereof is lower than that of an organic material used as a light emitting layer material, it is difficult to manufacture an organic light emitting diode having high efficiency and a long life span.

In addition, the material used in the organic light emitting diode should have excellent chemical stability, electric charge mobility, and interfacial characteristic with an electrode or an adjacent layer. That is, the material used in the organic light emitting diode should be little deformed by moisture or oxygen. Further, appropriate hole or electron mobility should be ensured so as to balance densities of the holes and the electrons in the light emitting layer of the organic light emitting diode, thus maximizing formation of excitons. In addition, an interface with an electrode comprising metal or metal oxides should be favorable for stability of the diode.

In order to sufficiently exhibit excellent characteristics of the aforementioned organic light emitting diode, a material forming the organic material layer in the diode, for example, the hole injection material, the hole transport material, the light emitting material, the electron transport material, the electron injection material, and the like should be supported by stable and efficient materials in advance, but development of a stable and efficient organic material layer material for organic light emitting diodes has not yet been sufficiently made, such that there is still a demand for developing a new material. WO 2011/040607 A1 discloses an aromatic amine derivative and an organic electroluminescent element comprising a cathode, an anode, and a monolayered or multilayered organic thin film layer comprising at least a light-emitting layer and intercalated between the cathode and the anode, wherein at least one layer of the organic thin film layer contains the aromatic amine derivative. KR20110061792 A discloses a compound containing dibenzocarbazole to be used as a hole injection layer or hole transport layer in an organic electric device.

### [Disclosure]

### [Technical Problem]

The present invention is defined by the claims and has been made in an effort to provide an organic light emitting diode having excellent characteristics comprising a low voltage, high efficiency, and a long life span, and a simple manufacturing process.

### [Technical Solution]

While the present invention is defined by the claims, an exemplary embodiment of the present invention provides an organic light emitting diode comprising an anode, a cathode, and one or more organic material layers interposed between the anode and the cathode,
in which the organic material layer comprises a light emitting layer, and
the organic material layer comprising a compound represented by any one of the following Formulae 4 and 5 and the organic material layer comprising a compound represented by the following Formula 2 are comprised between the anode and the light emitting layer. 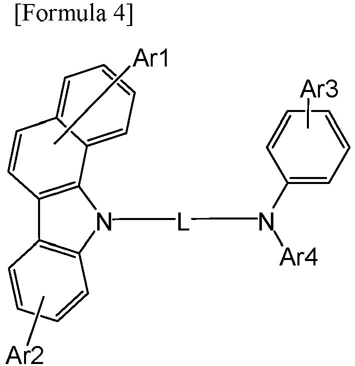 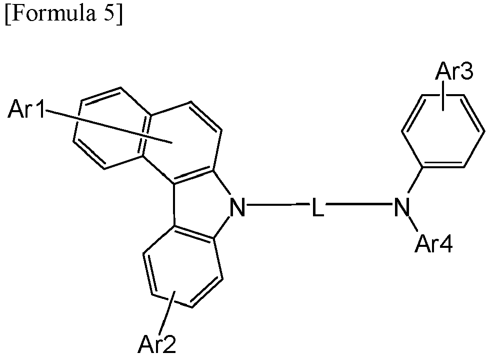 wherein in Formulae 4 and 5:
Ar1 to Ar2 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms,
Ar3 is selected from the group consisting of hydrogen; unsubstituted phenyl group, and unsubstituted biphenyl group,
Ar4 is selected from the group consisting of a substituted or unsubstituted phenyl group, a substituted or unsubstituted biphenyl group, a substituted or unsubstituted terphenyl group, a substituted or unsubstituted triphenyl group, a substituted or unsubstituted dibenzothiophene group, and a substituted or unsubstituted dibenzofuran group,
L is a substituted or unsubstituted arylene group having 6 to 30 carbon atoms; 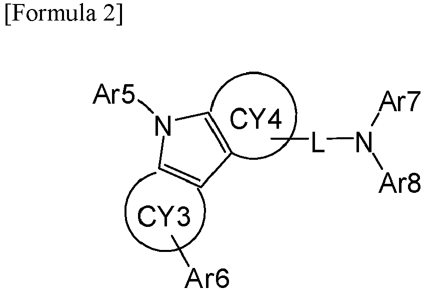
in Formula 2,
CY3 to CY4 are the same as or different from each other, and each independently represent a benzene cycle or a naphthalene cycle,
Ar5 to Ar6 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms,
Ar7 to Ar8 are the same as or different from each other, and each independently selected from the group consisting of hydrogen; a substituted or unsubstituted aryl group having 6 to 30 carbon atoms; unsubstituted dibenzothiophene group, and unsubstituted dibenzofuran group,
at least one of Ar7 and Ar8 is a substituted or unsubstituted fluorene group or a substituted or unsubstituted naphthyl group, and
L is a substituted or unsubstituted arylene group having 6 to 30 carbon atoms.

### [Advantageous Effects]

An organic light emitting diode according to the present invention comprises an exciton blocking layer comprising a compound represented by any one of Formula 4 and 5 to confine an exciton to a light emitting layer to prevent light emitting leakage, and thus there is an effect of implementing an organic electroluminescence diode having excellent light emitting efficiency. Accordingly, it is possible to implement an organic light emitting diode having a simple and economical manufacturing process, a low voltage, high efficiency, and a long life span as compared to the related art.

### [Brief Description of the Drawings]

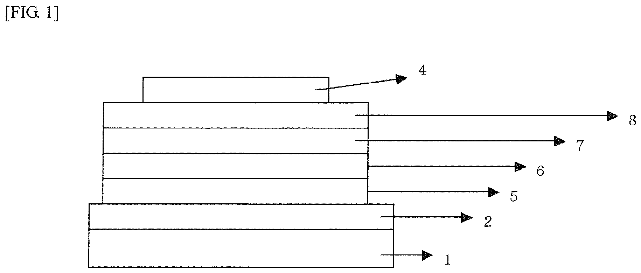

FIG. 1 illustrates an example of an organic light emitting diode formed of a substrate 1, an anode 2, a hole injection layer 5, a hole transport layer 6, a light emitting layer 7, an electron transport layer 8, and a cathode 4.

### [Best Mode]

Hereinafter, the present invention will be described in more detail.

In an organic light emitting diode, when a light emitting layer is formed, since a diffusion distance of a triple exciton is 100 nm or more, which is long, the triple exciton deviates from the light emitting layer having a thickness of 20 to 30 nm to largely reduce light emitting efficiency, and thus it is preferable to confine the triple exciton to the light emitting layer by using an appropriate exciton blocking layer.

An organic light emitting diode according to the present invention comprises an anode, a cathode, and one or more organic material layers interposed between the anode and the cathode, in which the organic material layer comprises a light emitting layer, and the organic material layer comprising a compound represented by any one of Formulae 4 and 5 and the organic material layer comprising a compound represented by Formula 2 are comprised between the anode and the light emitting layer.

In the organic light emitting diode according to the present invention, a hole transport layer is comprised between the anode and the light emitting layer, and comprises the compound represented by Formula 2.

In the organic light emitting diode according to the present invention, an electron blocking layer is comprised between the anode and the light emitting layer, and comprises the compound represented by any one of Formulas 4 and 5.

In this case, the electron blocking layer may be an organic material layer that is in contact with the light emitting layer.

In the organic light emitting diode according to the present invention, the electron blocking layer may act as the exciton blocking layer by comprising the compound represented by any one of Formulas 4 and 5.

In the organic light emitting diode according to the present invention, substituent groups of Formulas 4, 5 and 2 will be described in more detail below.

In Formulas 4 and 5, Ar4 is selected from the group consisting of a substituted or unsubstituted phenyl group, a substituted or unsubstituted biphenyl group, a substituted or unsubstituted terphenyl group, a substituted or unsubstituted triphenylene group, a substituted or unsubstituted dibenzothiophene group, and a substituted or unsubstituted dibenzofuran group. That is, in the definitions of Ar4, a substituted or unsubstituted fluorene group, and a substituted or unsubstituted naphthalene group are excluded.

Examples of the halogen group may comprise fluorine, chlorine, bromine, iodine, and the like, but are not limited thereto.

An alkyl group may be a straight chain or a branched chain, and specific examples thereof comprise a methyl group, an ethyl group, a propyl group, an isopropyl group, a butyl group, a t-butyl group, a pentyl group, a hexyl group, a heptyl group, and the like, but are not limited thereto.

An alkenyl group may be a straight chain or a branched chain, and specific examples thereof comprise an alkenyl group connected to an aryl group such as a stylbenyl group and a styrenyl group, but are not limited thereto.

Examples of an alkoxy group may comprise a methoxy group, an ethoxy group, an isopropyloxy group, and the like, but are not limited thereto.

An aryl group may be a monocycle type or a polycycle type. Examples of the monocyclic aryl group may comprise a phenyl group, a biphenyl group, a terphenyl group, stilben, and the like, and examples of the polycyclic aryl group may comprise a naphthyl group, an anthracenyl group, a phenanthrene group, a pyrenyl group, a perylenyl group, a cryxenyl group, a fluorene group, and the like, but are not limited thereto.

The heteroaryl group is a heteroatom and a cyclic group comprising O, N, S, or P, examples of a heterocyclic group comprise a carbazole group, a thiophene group, a furan group, a pyrrole group, an imidazole group, a thiazole group, an oxazole group, an oxadiazole group, a triazole group, a pyridyl group, a pyradazine group, a quinolynyl group, an isoquinolyn group, an acrydyl group, and the like, and the compounds of the following Structural Formulas are preferable but are not limited thereto.

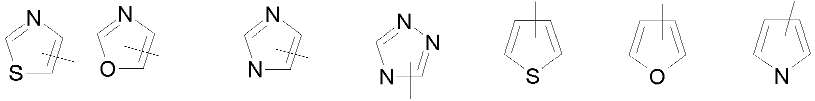

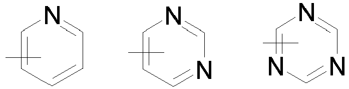

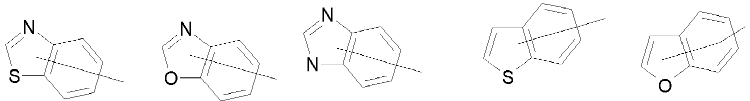

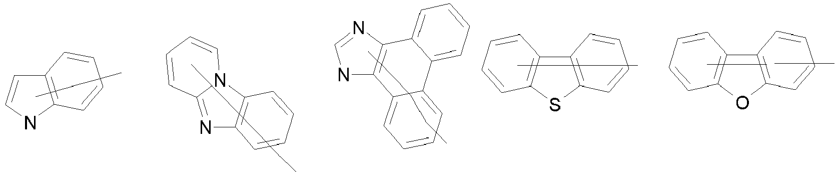

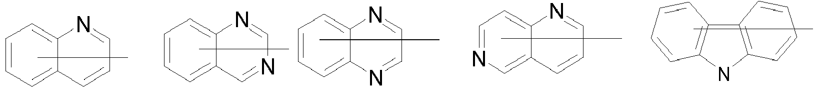

Further, in the present specification, the term "substituted or unsubstituted" means that substitution is performed by one or more substituent groups selected from the group consisting of heavy hydrogen, a halogen group, an alkyl group, an alkenyl group, an alkoxy group, a silyl group, an arylalkenyl group, an aryl group, a heteroaryl group, a carbazole group, an arylamine group, and a fluorenyl group and a nitrile group substituted or unsubstituted by an aryl group, or there is no substituent group.

CY3 to CY4, L, and Ar1 to Ar8 of Formulas 4, 5 and 2 are as defined in the claims and may be further substituted by additional substituent groups, and specific examples thereof may comprise a halogen group, an alkyl group, an alkenyl group, an alkoxy group, a silyl group, an arylalkenyl group, an aryl group, a heteroaryl group, a carbazole group, an arylamine group, a fluorenyl group substituted or unsubstituted by an aryl group, a nitrile group, and the like, but are not limited thereto.

In Formulas 4 and 5, Ar3 is preferably hydrogen or a phenyl group and Ar4 is preferably a phenyl group or a biphenyl group, but Ar3 and Ar4 are not limited thereto.

In Formulas 4 and 5, L is preferably a biphenyl group, but is not limited thereto.

The compound represented by Formulas 4 and 5 are as follows.

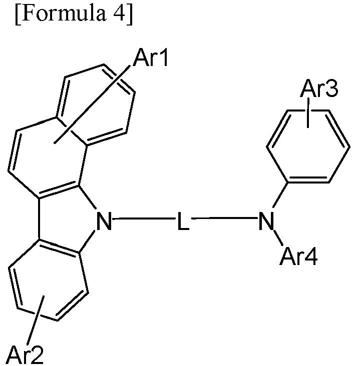

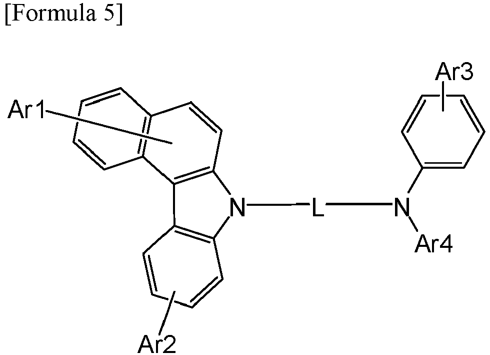

In Formulas 4 and 5,
Ar1 to Ar4, and L, and
Ar7 and Ar8 are as defined in the claims.

The compound represented by Formula 4 and 5 may be preferably selected from the group consisting of the following Structural Formulas, but is not limited thereto.

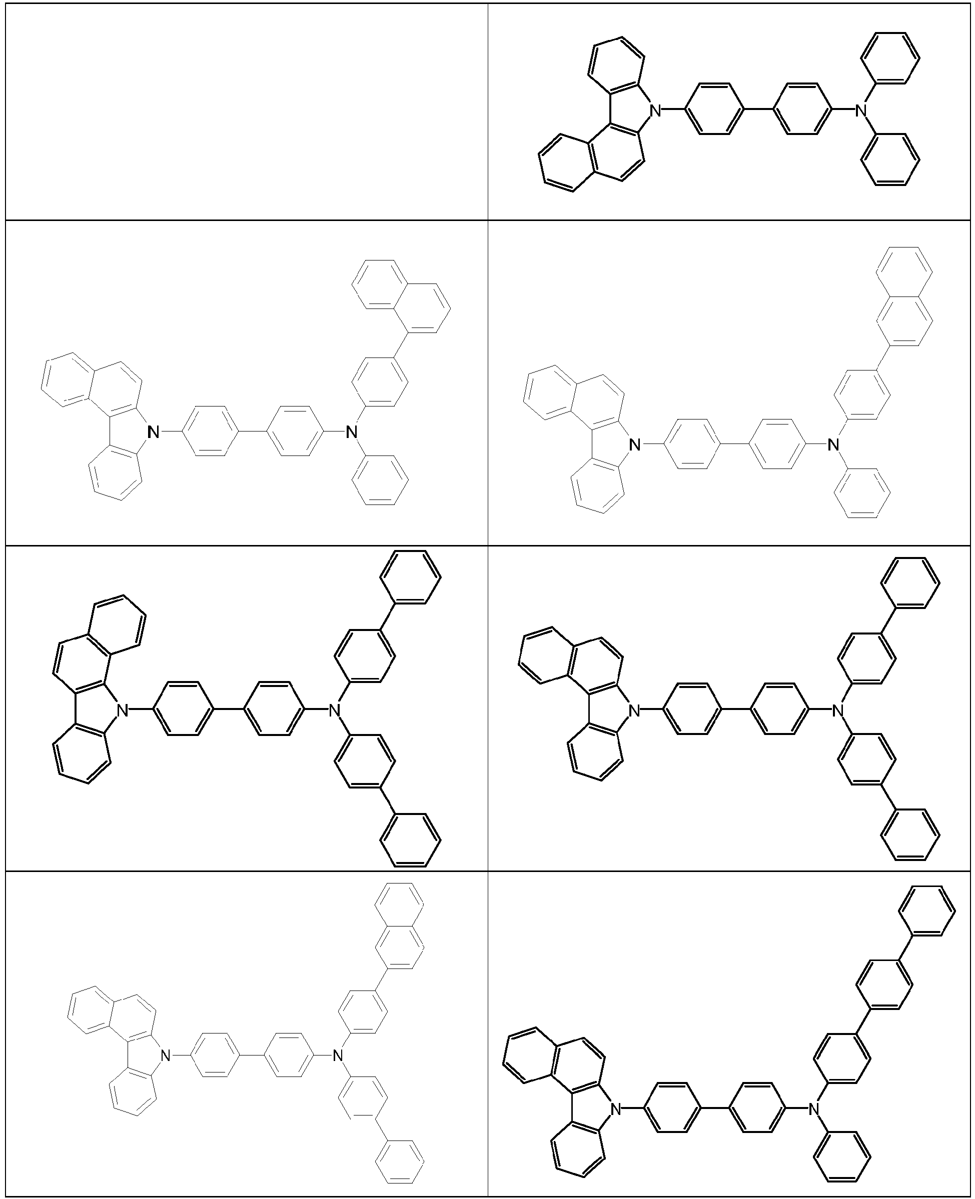

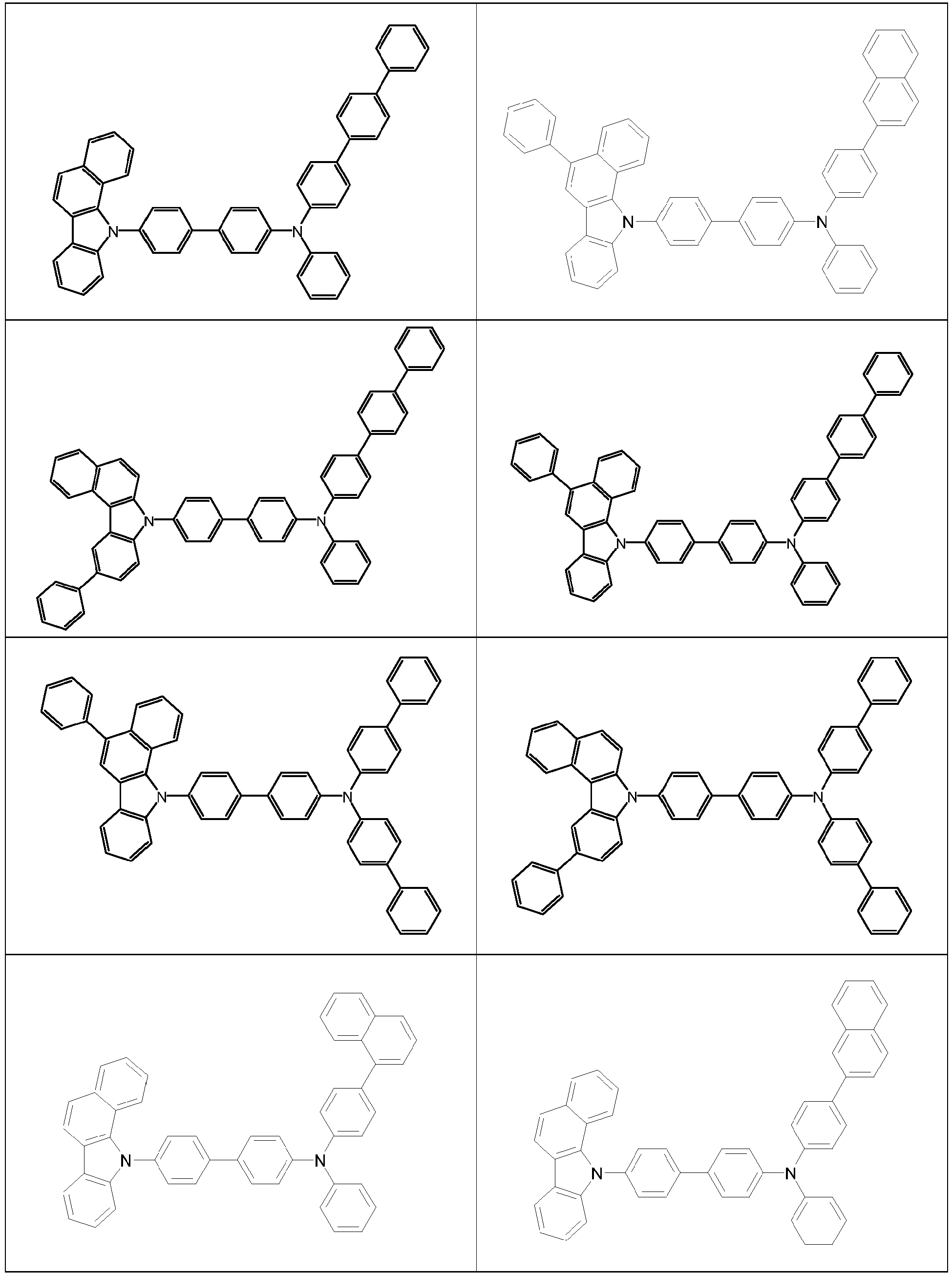

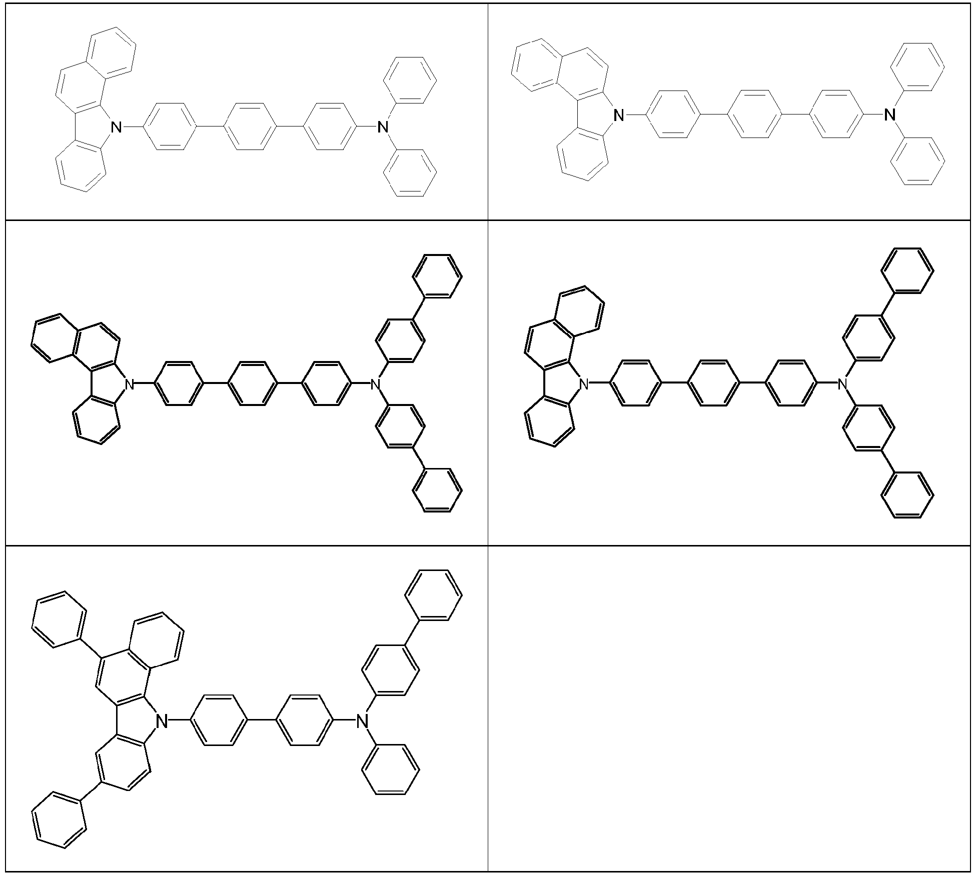

The compound represented by Formula 2 may be preferably selected from the group consisting of the following Structural Formulas, but is not limited thereto.

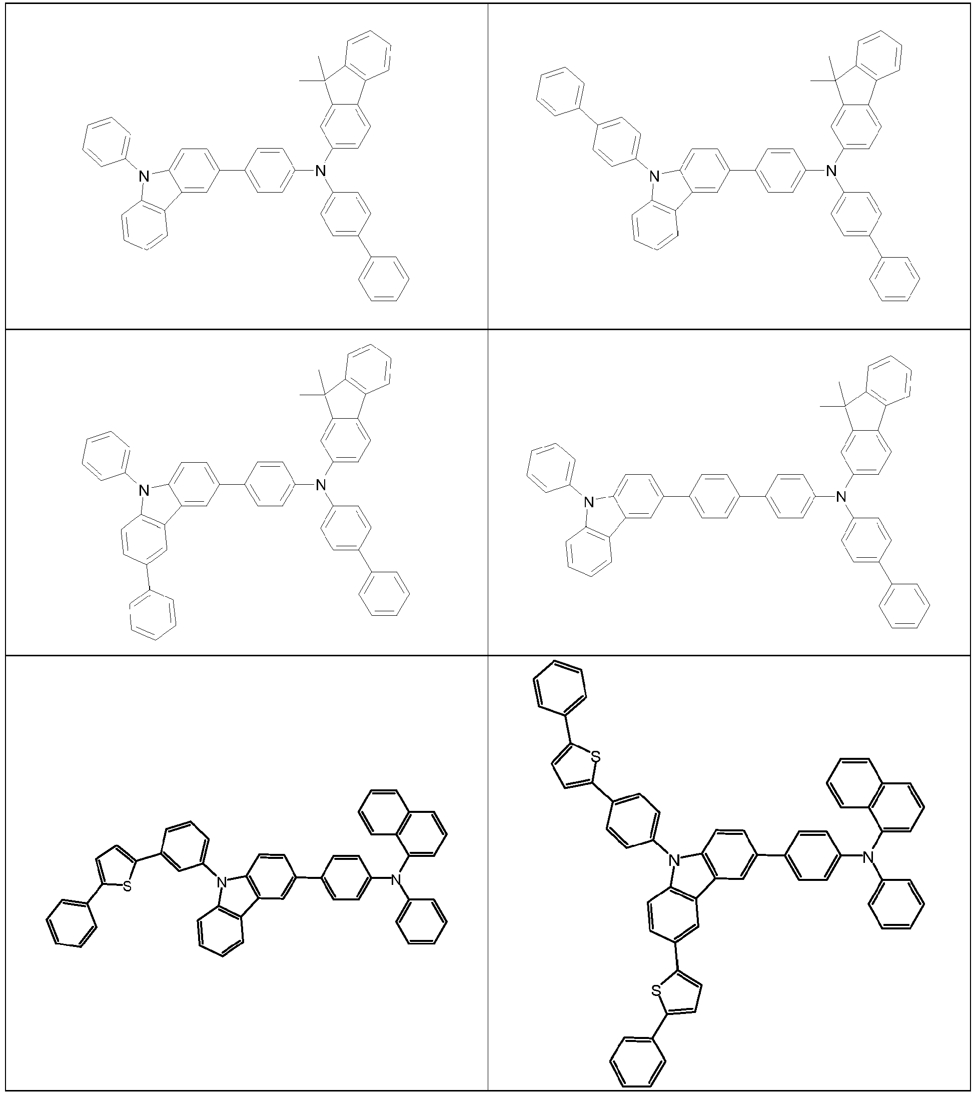

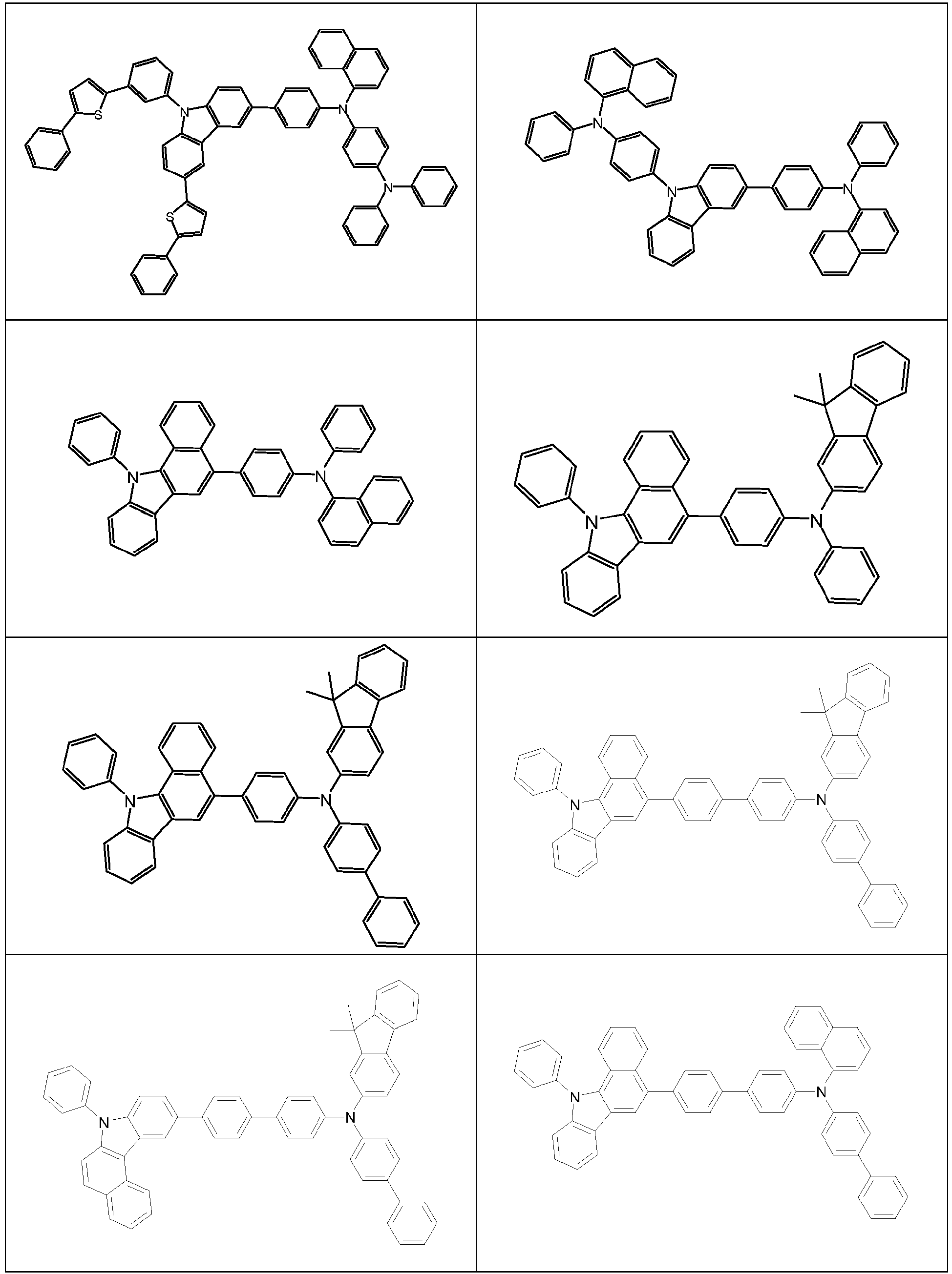

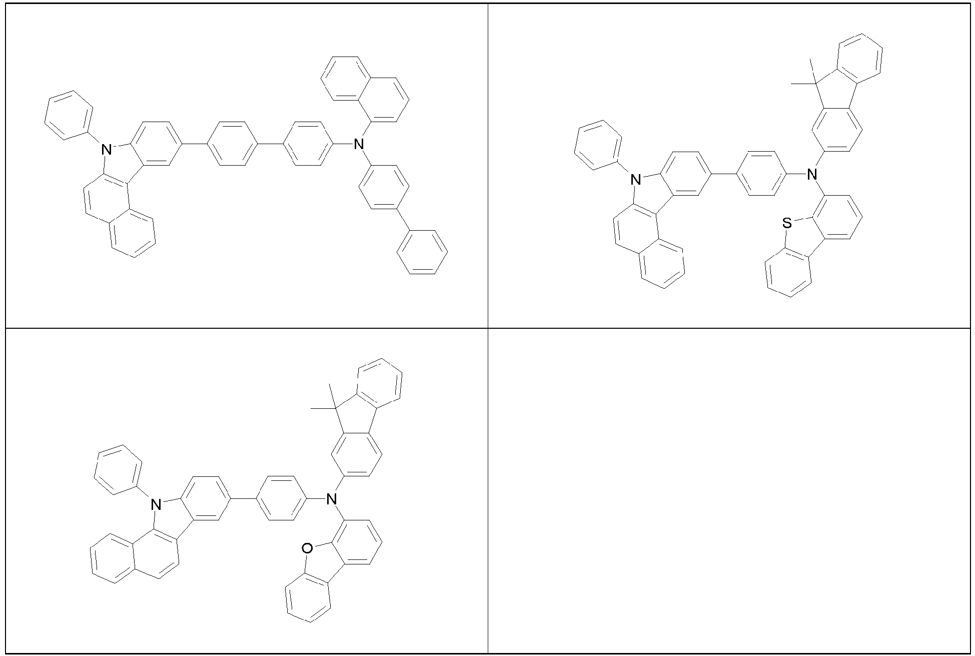

The organic light emitting diode according to the present invention may be manufactured by a manufacturing method and a material of a general organic light emitting diode, except that the one or more organic material layers are formed by using the aforementioned compounds.

The compounds represented by Formulas 4, 5 and 2 may form the organic material layer by a vacuum deposition method and a solution coating method when the organic light emitting diode is manufactured. Herein, the solution coating method means spin coating, dip coating, inkjet printing, screen printing, a spray method, roll coating, and the like, but is not limited thereto.

The organic material layer of the organic light emitting diode of the present invention may have a single layer structure, or a multilayered structure in which two or more organic material layers are laminated. For example, the organic light emitting diode of the present invention may have a structure comprising a hole injection layer, a hole transport layer, a light emitting layer, an electron transport layer, an electron injection layer, and the like as an organic material layer. However, the structure of the organic light emitting diode is not limited thereto, but may comprise a smaller number of organic material layers.

For example, the structure of the organic light emitting diode of the present invention may have a structure illustrated in FIG. 1, but is not limited thereto.

FIG. 1 illustrates a structure of an organic light emitting diode, in which an anode 2, a hole injection layer 5, a hole transport layer 6, a light emitting layer 7, an electron transport layer 8, and a cathode 4 are sequentially laminated on a substrate 1. In the aforementioned structure, the compound represented by Formula 2 is comprised in the hole transport layer 6.

For example, the organic light emitting diode according to the present invention may be manufactured by depositing metal, metal oxides having conductivity, or an alloy thereof on the substrate by using a PVD (physical vapor deposition) method such as sputtering or e-beam evaporation to form the anode, forming the organic material layer comprising the hole injection layer, the hole transport layer, the light emitting layer, and the electron transport layer thereon, and depositing the material that can be used as the cathode thereon. In addition to the aforementioned method, the organic light emitting diode may be manufactured by sequentially depositing a cathode material, an organic material layer, and an anode material on the substrate.

The organic material layer may have a multilayered structure comprising the hole injection layer, the hole transport layer, the light emitting layer, the electron transport layer, and the like, but is not limited thereto and may have a single layer structure. Further, the organic material layer may be manufactured to have the smaller number of layers by using various polymer materials and by not the deposition method but the solvent process, for example, a method such as spin coating, dip coating, doctor blading, screen printing, inkjet printing, or a heat transferring method.

It is preferable that the anode material be, in general, a material having a large work function so as to smoothly inject holes into the organic material layer. Specific examples of the anode material that can be used in the present invention comprise metal such as vanadium, chrome, copper, zinc, and gold, or an alloy thereof; metal oxides such as zinc oxides, indium oxides, indium tin oxides (ITO), and indium zinc oxides (IZO); a combination of metal and oxides such as ZnO:Al or SnO₂:Sb; conductive polymers such as poly(3-methyl compound), poly[3,4-(ethylene-1,2-dioxy) compound](PEDT), polypyrole, and polyaniline, and the like, but are not limited thereto.

It is preferable that the cathode material be, in general, a material having a small work function so as to easily inject electrons into the organic material layer. Specific examples of the cathode material comprise metal such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

The hole injection material is a material that can well receive holes from the anode at a low voltage, and it is preferable that a HOMO (highest occupied molecular orbital) of the hole injection material be a value between a work function of the anode material and the HOMO of the organic material layer therearound. Specific examples of the hole injection material comprise metal porphyrine, oligothiophene, an arylamine-based organic material, a hexanitrilehexaazatriphenylene-based organic material, a quinacridone-based organic material, a perylene-based organic material, anthraquinone, polyaniline, a polycompound-based conductive polymer, and the like, but are not limited thereto.

The hole transport material is a material that can receive the holes from the anode or the hole injection layer and transport the holes to the light emitting layer, and is preferably a material having large mobility to the holes. Specific examples thereof comprise an arylamine-based organic material, a conductive polymer, a block copolymer in which a conjugate portion and a non-conjugate portion are present together, and the like, but are not limited thereto.

The light emitting material is a material that can receive the holes and the electrons from the hole transport layer and the electron transport layer, respectively, and bond the holes and the electrons to emit light in a visible ray region, and is preferably a material having good quantum efficiency to fluorescence or phosphorescence. Specific examples thereof comprise a 8-hydroxy-quinoline aluminum complex (Alq₃); a carbazole-based compound; a dimerized styryl compound; BAlq; a 10-hydroxybenzoquinoline-metal compound; a benzoxazole, benzthiazole and benzimidazole-based compound; a poly(p-phenylenevinylene) (PPV)-based polymer; a spiro compound; polyfluorene, lubrene, and the like, but are not limited thereto.

Particularly, in the organic light emitting diode according to the present invention, it is preferable that the light emitting layer comprise a blue fluorescent material or a green phosphorescent material.

The electron transport material is a material that can receive well the electrons from the cathode and transport the electrons to the light emitting layer, and is preferably a material having large mobility to the electrons. Specific examples thereof comprise a 8-hydroxyquinoline Al complex; a complex comprising Alq₃; an organic radical compound; a hydroxyflavone-metal complex, and the like, but are not limited thereto.

The organic light emitting diode according to the present invention may be a top emission type, a bottom emission type, or a both-sided emission type according to the used material. Further, the organic light emitting diode according to the present invention may have a positive structure in which a lower electrode is the anode and an upper electrode is the cathode, or a negative structure in which the lower electrode is the cathode and the upper electrode is the anode.

The compound according to the present invention may function even in an organic electronic diode such as an organic solar cell, an organic photoconductor, and an organic transistor based on the principle that is similar to the principle applied to the organic light emitting diode.

The organic light emitting diode according to the present invention comprises the exciton and electron blocking layer comprising the compound represented by Formulas 4 or 5 to confine an exciton to the light emitting layer to prevent light emitting leakage, and thus there is an effect of implementing an organic electroluminescence diode having excellent light emitting efficiency. Accordingly, it is possible to implement an organic light emitting diode having a simple and economical manufacturing process, a low voltage, high efficiency, and a long life span as compared to the related art.

### [Mode for Invention]

Hereinafter, preferable Examples will be described in order to help understanding of the present invention. However, the following Examples are set forth to illustrate the present invention, but the scope of the present invention is not limited thereto.

### <Example> (Examples 1, 2, 5, 6, 9 and 10 are Reference Examples)

### <Example 1> Manufacturing of the organic light emitting diode

The glass substrate (corning 7059 glass) on which the thin film of ITO (indium tin oxide) was applied to a thickness of 1,000 Å was immersed in distilled water having the detergent dissolved therein, and washed by the ultrasonic wave. In this case, the detergent as used herein was the product commercially available from Fischer Co. and the distilled water was one which had been twice filtered by using the filter commercially available from Millipore Co. ITO was washed for 30 mins, and washing with ultrasonic waves was then repeated twice for 10 mins by using distilled water. After the completion of washing with distilled water, washing with ultrasonic waves was performed by using solvents such as isopropyl alcohol, acetone, and methanol, and the resulting product was dried and transported to the plasma washing machine. Further, the substrate was dry-washed by using the oxygen plasma for 5 mins, and then transported to the vacuum deposition machine.

Hexanitrile hexaazatriphenylene (hereinafter, referred to as "HAT") that was the compound of the following Formula was deposited under the heat vacuum in a thickness of 100 Å on the prepared ITO transparent electrode to form the thin film. The interfacial characteristic between the substrate and the hole injection layer can be improved by the thin film. Subsequently, the compound of Formula HT-1 was deposited in a thickness of 800 Å on the thin film to form the hole transport layer, and the compound of the following Formula EB-4 was deposited in a thickness of 200 Å thereon to form the electron blocking layer. Subsequently, 10 wt% of the compound of Formula PD-1 was doped onto the compound of Formula PH-1 to form the light emitting layer in a thickness of 300 Å. The compound of Formula HB-1 was deposited in a thickness of 50 Å thereon to form the hole blocking layer, and subsequently, the electron transport layer material of Formula ET-1 was deposited in a thickness of 300 Å to form the electron transport layer. Lithium fluoride (LiF) in a thickness of 12 Å and aluminum in a thickness of 2,000 Å were sequentially deposited on the electron transport layer to form the cathode.

In the aforementioned process, the deposition rate of the organic material was maintained at 0.3 to 0.8 Å/sec. Further, the deposition rate of lithium fluoride of the cathode was maintained at 0.3 Å/sec, and the deposition rate of aluminum was maintained at 1.5 to 2.5 Å/sec. The degree of vacuum during the deposition was maintained at 1 to 3 × 10⁻⁷.

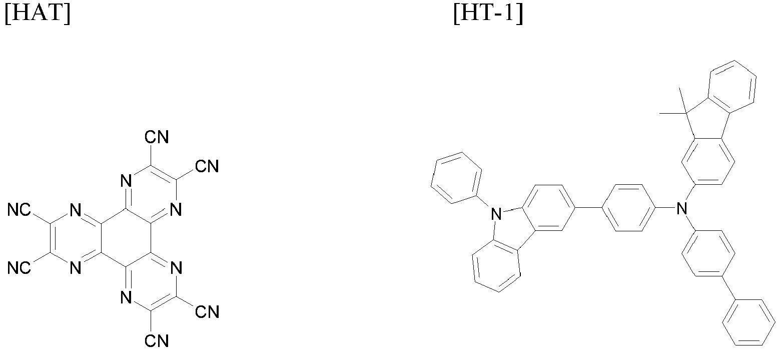

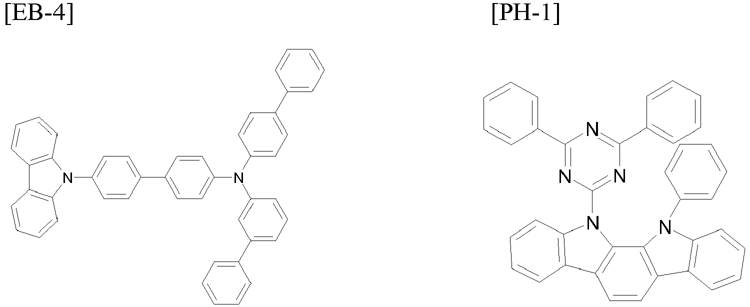

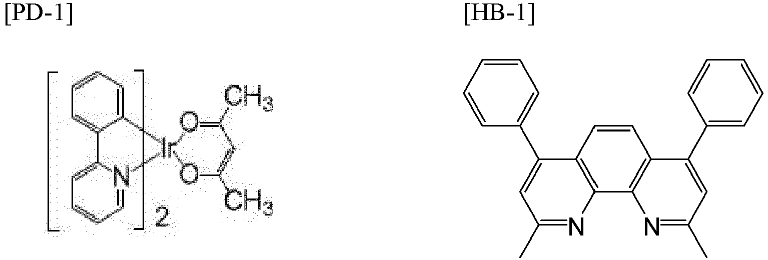

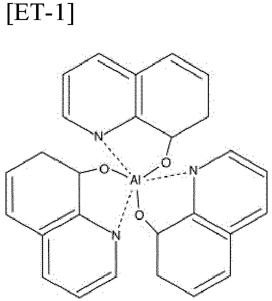

### <Example 2> Manufacturing of the organic light emitting diode

The same diode was manufactured, except that the compound of Formula EB-4 used as the electron blocking layer in Example 1 was substituted by the compound of the following Formula EB-5.

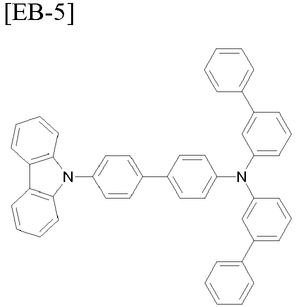

### <Example 3> Manufacturing of the organic light emitting diode

The same diode was manufactured, except that the compound of Formula EB-4 used as the electron blocking layer in Example 1 was substituted by the compound of the following Formula EB-6.

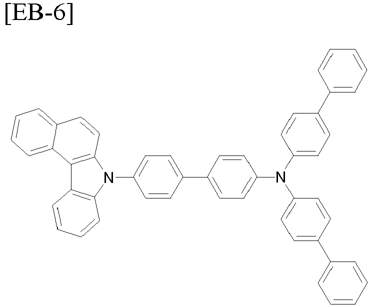

### <Example 4> Manufacturing of the organic light emitting diode

The same diode was manufactured, except that the compound of Formula EB-4 used as the electron blocking layer in Example 1 was substituted by the compound of the following Formula EB-7.

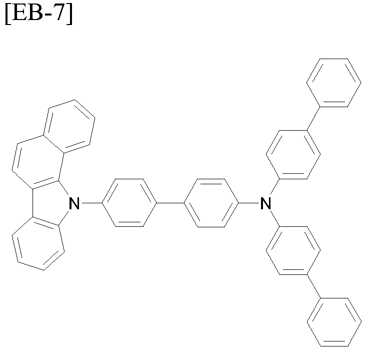

### <Example 5> Manufacturing of the organic light emitting diode

The same diode was manufactured, except that the compound of Formula HT-1 used as the hole transport layer in Example 1 was substituted by the compound of the following Formula HT-2.

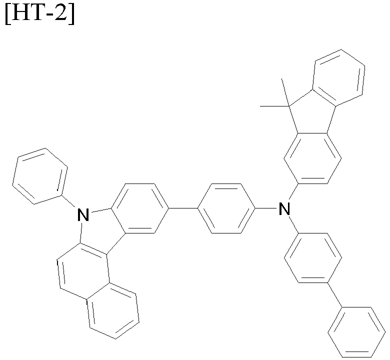

### <Example 6> Manufacturing of the organic light emitting diode

The same diode was manufactured, except that the compound of Formula HT-1 used as the hole transport layer in Example 2 was substituted by the compound of Formula HT-2.

### <Example 7> Manufacturing of the organic light emitting diode

The same diode was manufactured, except that the compound of Formula HT-1 used as the hole transport layer in Example 3 was substituted by the compound of Formula HT-2.

### <Example 8> Manufacturing of the organic light emitting diode

The same diode was manufactured, except that the compound of Formula HT-1 used as the hole transport layer in Example 4 was substituted by the compound of Formula HT-2.

### <Example 9> Manufacturing of the organic light emitting diode

The same diode was manufactured, except that the compound of Formula HT-1 used as the hole transport layer in Example 1 was substituted by the compound of the following Formula HT-3.

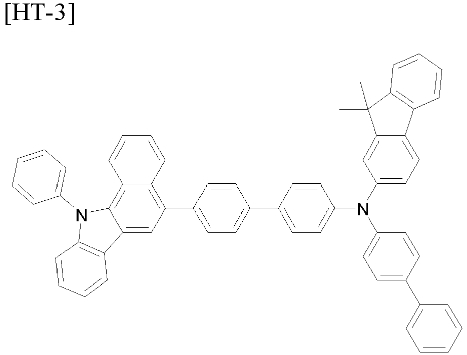

### <Example 10> Manufacturing of the organic light emitting diode

The same diode was manufactured, except that the compound of Formula HT-1 used as the hole transport layer in Example 2 was substituted by the compound of Formula HT-3.

### <Example 11> Manufacturing of the organic light emitting diode

The same diode was manufactured, except that the compound of Formula HT-1 used as the hole transport layer in Example 3 was substituted by the compound of Formula HT-3.

### <Example 12> Manufacturing of the organic light emitting diode

The same diode was manufactured, except that the compound of Formula HT-1 used as the hole transport layer in Example 4 was substituted by the compound of Formula HT-3.

The driving voltage and light emitting efficiency of the organic light emitting diode manufactured by the aforementioned method were measured at the current density of 10 mA/cm², and the time (LT90) at which brightness was 90% of initial brightness was measured at the current density of 20 mA/cm². The result is described in the following Table 1.

**[Table 1]**

| Example | Voltage (V) | Light emitting efficiency (cd/A) | CIE-x | CIE-y | LT90 (hr) at 20 mA/cm² |
|---|---|---|---|---|---|
| 1 | 5.3 | 69.9 | 0.443 | 0.546 | 333.9 |
| 2 | 6.2 | 66.3 | 0.443 | 0.545 | 345.9 |
| 3 | 5.8 | 62.6 | 0.446 | 0.543 | 396.0 |
| 4 | 4.0 | 63.0 | 0.438 | 0.550 | 389.0 |
| 5 | 4.4 | 61.5 | 0.439 | 0.549 | 423.1 |
| 6 | 4.6 | 69.7 | 0.440 | 0.548 | 421.1 |
| 7 | 4.5 | 71.8 | 0.433 | 0.554 | 414.7 |
| 8 | 4.2 | 73.0 | 0.428 | 0.559 | 400.0 |
| 9 | 4.1 | 70.7 | 0.423 | 0.562 | 467.1 |
| 10 | 4.8 | 73.1 | 0.442 | 0.546 | 450.8 |
| 11 | 4.7 | 74.3 | 0.435 | 0.552 | 431.0 |
| 12 | 4.5 | 74.1 | 0.429 | 0.557 | 400.0 |

### <Comparative Example 1> Manufacturing of the organic light emitting diode

The same diode was manufactured, except that the compound of Formula EB-4 used as the electron blocking layer in Example 1 was substituted by the compound of the following Formula EB-1.

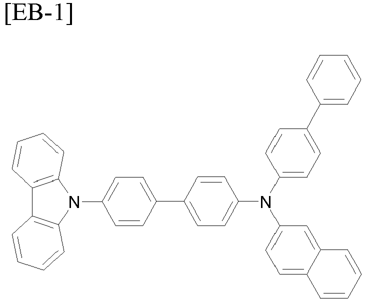

### <Comparative Example 2> Manufacturing of the organic light emitting diode

The same diode was manufactured, except that the compound of Formula EB-4 used as the electron blocking layer in Example 1 was substituted by the compound of the following Formula EB-2.

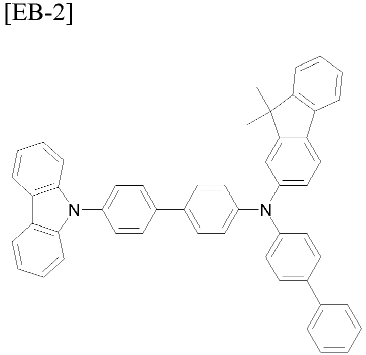

### <Comparative Example 3> Manufacturing of the organic light emitting diode

The same diode was manufactured, except that the compound of Formula EB-4 used as the electron blocking layer in Example 1 was substituted by the compound of the following Formula EB-3.

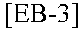

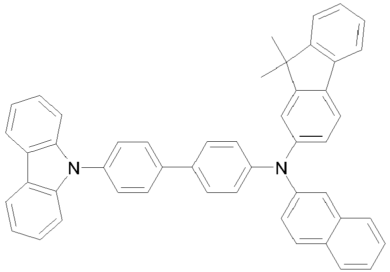

### <Comparative Example 4> Manufacturing of the organic light emitting diode

The same diode was manufactured, except that the compound of Formula EB-4 used as the electron blocking layer in Example 5 was substituted by the compound of Formula EB-1.

### <Comparative Example 5> Manufacturing of the organic light emitting diode

The same diode was manufactured, except that the compound of Formula EB-4 used as the electron blocking layer in Example 5 was substituted by the compound of Formula EB-2.

### <Comparative Example 6> Manufacturing of the organic light emitting diode

The same diode was manufactured, except that the compound of Formula EB-4 used as the electron blocking layer in Example 5 was substituted by the compound of Formula EB-3.

### <Comparative Example 7> Manufacturing of the organic light emitting diode

The same diode was manufactured, except that the compound of Formula EB-4 used as the electron blocking layer in Example 9 was substituted by the compound of Formula EB-1.

### <Comparative Example 8> Manufacturing of the organic light emitting diode

The same diode was manufactured, except that the compound of Formula EB-4 used as the electron blocking layer in Example 9 was substituted by the compound of Formula EB-2.

### <Comparative Example 9> Manufacturing of the organic light emitting diode

The same diode was manufactured, except that the compound of Formula EB-4 used as the electron blocking layer in Example 9 was substituted by the compound of Formula EB-3.

### <Comparative Example 10> Manufacturing of the organic light emitting diode

The same diode was manufactured, except that the compound of Formula HT-1 used as the hole transport layer in Example 1 was substituted by the compound of the following Formula HT-4 and the compound of Formula EB-4 used as the electron blocking layer was substituted by the compound of Formula EB-1.

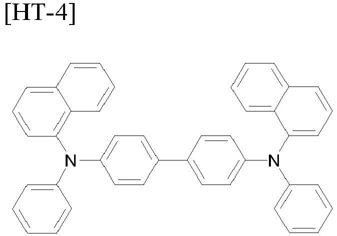

### <Comparative Example 11> Manufacturing of the organic light emitting diode

The same diode was manufactured, except that the compound of Formula HT-1 used as the hole transport layer in Example 1 was substituted by the compound of Formula HT-4 and the compound of Formula EB-4 used as the electron blocking layer was substituted by the compound of Formula EB-2.

### <Comparative Example 12> Manufacturing of the organic light emitting diode

The same diode was manufactured, except that the compound of Formula HT-1 used as the hole transport layer in Example 1 was substituted by the compound of Formula HT-4 and the compound of Formula EB-4 used as the electron blocking layer was substituted by the compound of Formula EB-3.

### <Comparative Example 13> Manufacturing of the organic light emitting diode

The same diode was manufactured, except that the compound of Formula HT-1 used as the hole transport layer in Example 1 was substituted by the compound of the following Formula HT-5 and the compound of Formula EB-4 used as the electron blocking layer was substituted by the compound of Formula EB-1.

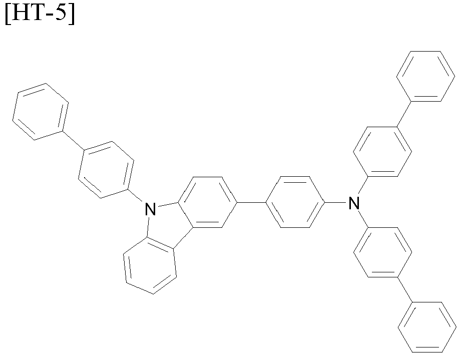

### <Comparative Example 14> Manufacturing of the organic light emitting diode

The same diode was manufactured, except that the compound of Formula HT-1 used as the hole transport layer in Example 1 was substituted by the compound of Formula HT-5 and the compound of Formula EB-4 used as the electron blocking layer was substituted by the compound of Formula EB-2.

### <Comparative Example 15> Manufacturing of the organic light emitting diode

The same diode was manufactured, except that the compound of Formula HT-1 used as the hole transport layer in Example 1 was substituted by the compound of Formula HT-5 and the compound of Formula EB-4 used as the electron blocking layer was substituted by the compound of Formula EB-3.

### <Comparative Example 16> Manufacturing of the organic light emitting diode

The same diode was manufactured, except that the compound of Formula HT-1 used as the hole transport layer in Example 1 was substituted by the compound of Formula HT-4.

### <Comparative Example 17> Manufacturing of the organic light emitting diode

The same diode was manufactured, except that the compound of Formula HT-1 used as the hole transport layer in Example 2 was substituted by the compound of Formula HT-4.

### <Comparative Example 18> Manufacturing of the organic light emitting diode

The same diode was manufactured, except that the compound of Formula HT-1 used as the hole transport layer in Example 3 was substituted by the compound of Formula HT-4.

### <Comparative Example 19> Manufacturing of the organic light emitting diode

The same diode was manufactured, except that the compound of Formula HT-1 used as the hole transport layer in Example 4 was substituted by the compound of Formula HT-4.

### <Comparative Example 20> Manufacturing of the organic light emitting diode

The same diode was manufactured, except that the compound of Formula HT-1 used as the hole transport layer in Example 1 was substituted by the compound of Formula HT-5.

### <Comparative Example 21> Manufacturing of the organic light emitting diode

The same diode was manufactured, except that the compound of Formula HT-1 used as the hole transport layer in Example 2 was substituted by the compound of Formula HT-5.

### <Comparative Example 22> Manufacturing of the organic light emitting diode

The same diode was manufactured, except that the compound of Formula HT-1 used as the hole transport layer in Example 3 was substituted by the compound of Formula HT-5.

### <Comparative Example 23> Manufacturing of the organic light emitting diode

The same diode was manufactured, except that the compound of Formula HT-1 used as the hole transport layer in Example 4 was substituted by the compound of Formula HT-5.

The driving voltage and light emitting efficiency of the organic light emitting diode manufactured by the aforementioned method were measured at the current density of 10 mA/cm², and the time (LT90) at which brightness was 90% of initial brightness was measured at the current density of 20 mA/cm². The result is described in the following Table 2.

**[Table 2]**

| Comparative Example | Voltage (V) | Light emitting efficiency (cd/A) | CIE-x | CIE-y | LT90 (hr) at 20 mA/cm² |
|---|---|---|---|---|---|
| 1 | 6.5 | 59.9 | 0.407 | 0.573 | 229.8 |
| 2 | 9.5 | 61.8 | 0.437 | 0.551 | 229.1 |
| 3 | 7.6 | 61.2 | 0.436 | 0.552 | 229.7 |
| 4 | 9.4 | 61.4 | 0.428 | 0.558 | 231.3 |
| 5 | 5.8 | 60.5 | 0.432 | 0.555 | 232.4 |
| 6 | 8.5 | 59.3 | 0.426 | 0.560 | 232.3 |
| 7 | 8.4 | 60.2 | 0.427 | 0.559 | 233.0 |
| 8 | 7.3 | 59.9 | 0.432 | 0.554 | 235.6 |
| 9 | 5.1 | 59.2 | 0.431 | 0.555 | 237.1 |
| 10 | 5.0 | 54.5 | 0.432 | 0.542 | 192.9 |
| 11 | 6.1 | 54.1 | 0.449 | 0.540 | 195.5 |
| 12 | 7.2 | 53.6 | 0.446 | 0.542 | 196.1 |
| 13 | 4.7 | 53.9 | 0.442 | 0.542 | 197.7 |
| 14 | 6.0 | 51.6 | 0.458 | 0.529 | 198.7 |
| 15 | 5.5 | 53.6 | 0.443 | 0.545 | 197.7 |
| 16 | 5.9 | 54.1 | 0.445 | 0.537 | 202.6 |
| 17 | 6.2 | 50.3 | 0.422 | 0.562 | 203.5 |
| 18 | 3.7 | 51.0 | 0.439 | 0.544 | 200.9 |
| 19 | 4.2 | 54.2 | 0.444 | 0.545 | 201.9 |
| 20 | 8.3 | 59.2 | 0.425 | 0.560 | 248.5 |
| 21 | 7.7 | 59.2 | 0.434 | 0.553 | 240.9 |
| 22 | 8.4 | 59.4 | 0.429 | 0.557 | 243.9 |
| 23 | 7.1 | 58.7 | 0.420 | 0.564 | 250.6 |

It can be confirmed that the organic light emitting diodes of Examples 1 to 12 have high light emitting efficiency and the improved diode life span, and through this, it can be confirmed that light emitting and life span characteristics of the diode can be improved through a combination of the hole transport layer material having the structure in which the fluorene group or the naphthalene group is directly connected to amine and the electron blocking layer material having the structure in which the fluorene group or the naphthalene group is not directly connected to amine.

## Claims

1. An organic light emitting diode comprising an anode (2), a cathode (4), and one or more organic material layers interposed between the anode and the cathode,
wherein the organic material layer comprises a light emitting layer (7), **characterized in that** the organic material layer comprising a compound represented by any one of the following Formulas 4 and 5 and the organic material layer comprising a compound represented by the following Formula 2 are comprised between the anode and the light emitting layer (7),
the organic material layer comprising a compound represented by the Formula 2 is a hole transport layer (6), and
the organic material layer comprising a compound represented by any one of the following Formulas 4 and 5, is an electron blocking layer: 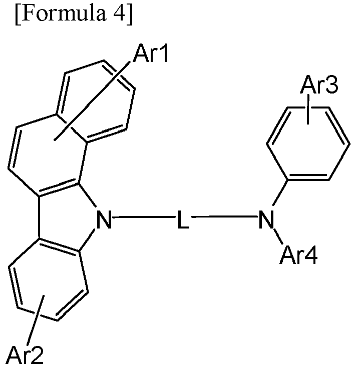 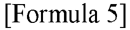 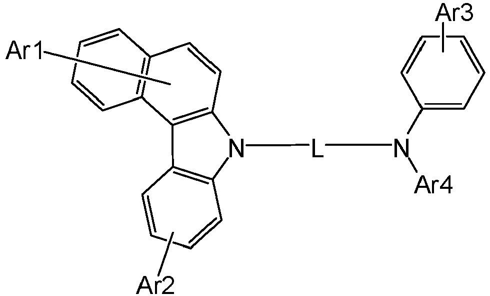 wherein in Formulae 4 and 5:
Ar1 to Ar2 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms,
Ar3 is selected from the group consisting of hydrogen; unsubstituted phenyl group, and unsubstituted biphenyl group,
Ar4 is selected from the group consisting of a substituted or unsubstituted phenyl group, a substituted or unsubstituted biphenyl group, a substituted or unsubstituted terphenyl group, a substituted or unsubstituted triphenyl group, a substituted or unsubstituted dibenzothiophene group, and a substituted or unsubstituted dibenzofuran group,
L is a substituted or unsubstituted arylene group having 6 to 30 carbon atoms; 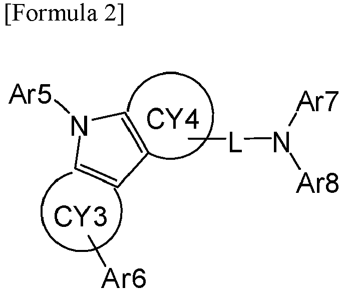
wherein in Formula 2:
CY3 to CY4 are the same as or different from each other, and each independently represent a benzene cycle or a naphthalene cycle,
Ar5 to Ar6 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms,
Ar7 to Ar8 are the same as or different from each other, and each independently selected from the group consisting of hydrogen; a substituted or unsubstituted aryl group having 6 to 30 carbon atoms; unsubstituted dibenzothiophene group, and unsubstituted dibenzofuran group,
at least one of Ar7 and Ar8 is a substituted or unsubstituted fluorene group or a substituted or unsubstituted naphthyl group, and
L is a substituted or unsubstituted arylene group having 6 to 30 carbon atoms.

2. The organic light emitting diode of claim 1, wherein the electron blocking layer is an organic material layer that is in contact with the light emitting layer.

3. The organic light emitting diode of claim 1, wherein Ar3 is hydrogen or a phenyl group, and Ar4 is a phenyl group or a biphenyl group.

4. The organic light emitting diode of claim 1, wherein L is a biphenylene group.

5. The organic light emitting diode of claim 1, wherein the compound represented by any one of the following Formulas 4and 5 is selected from the group consisting of the following Structural Formulas:

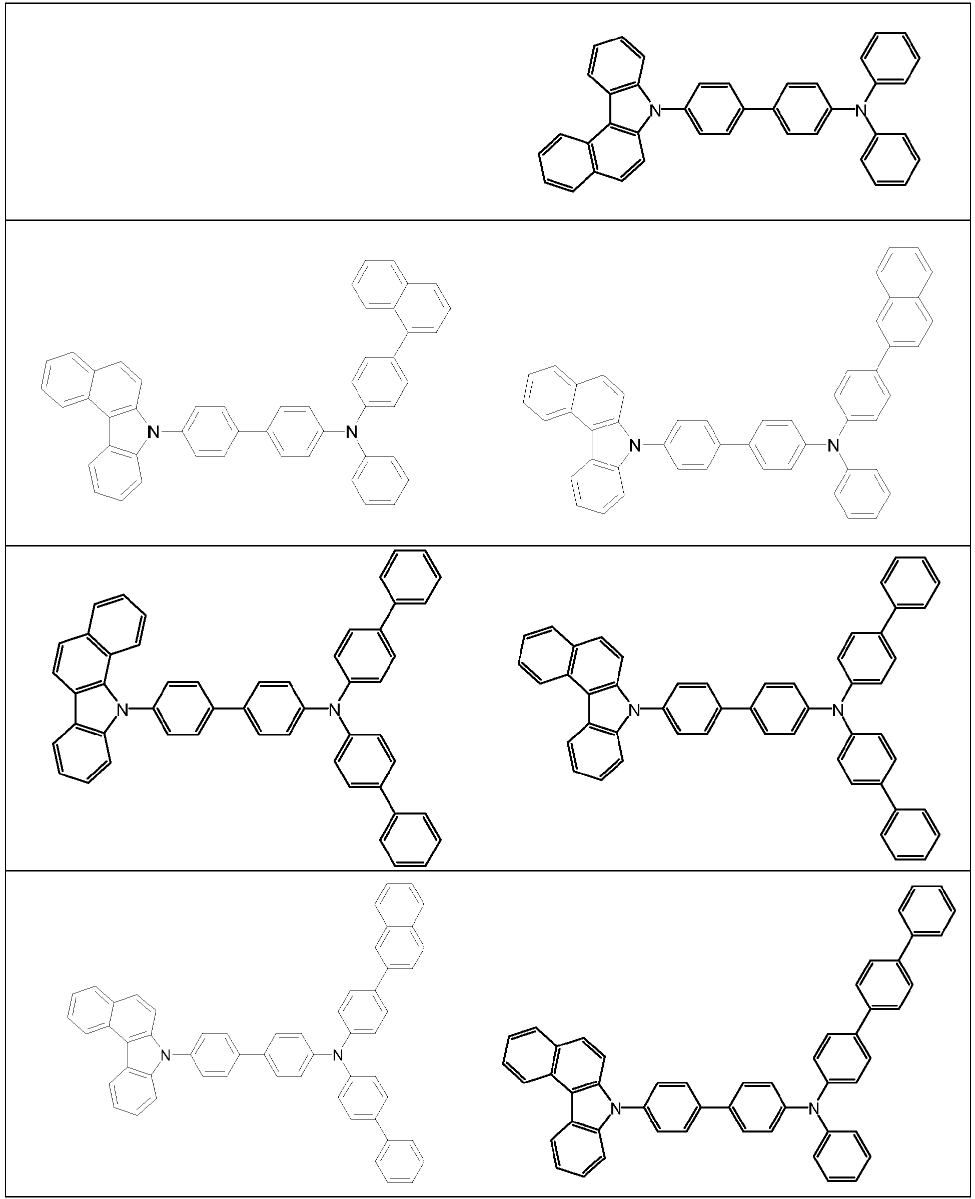

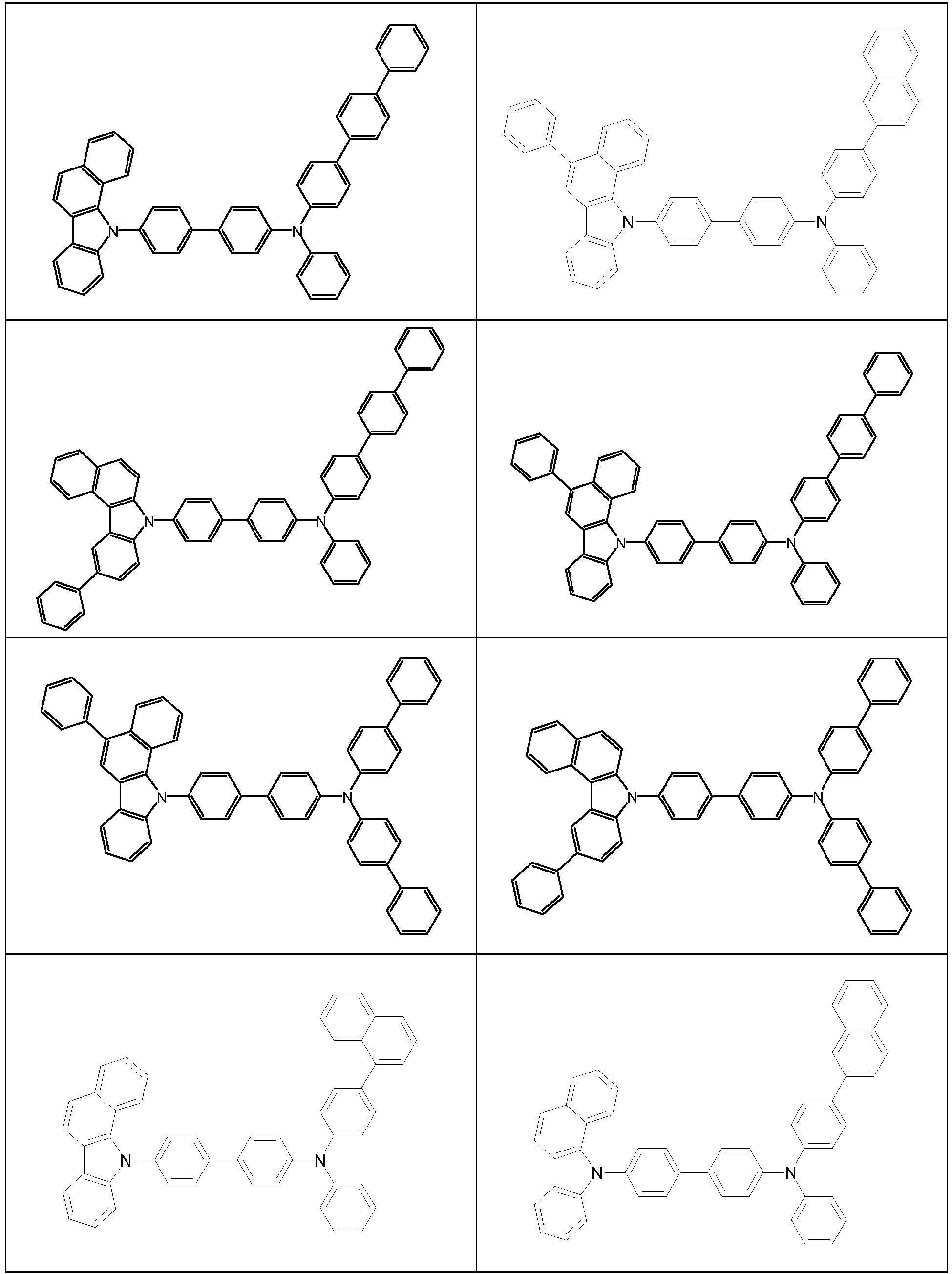

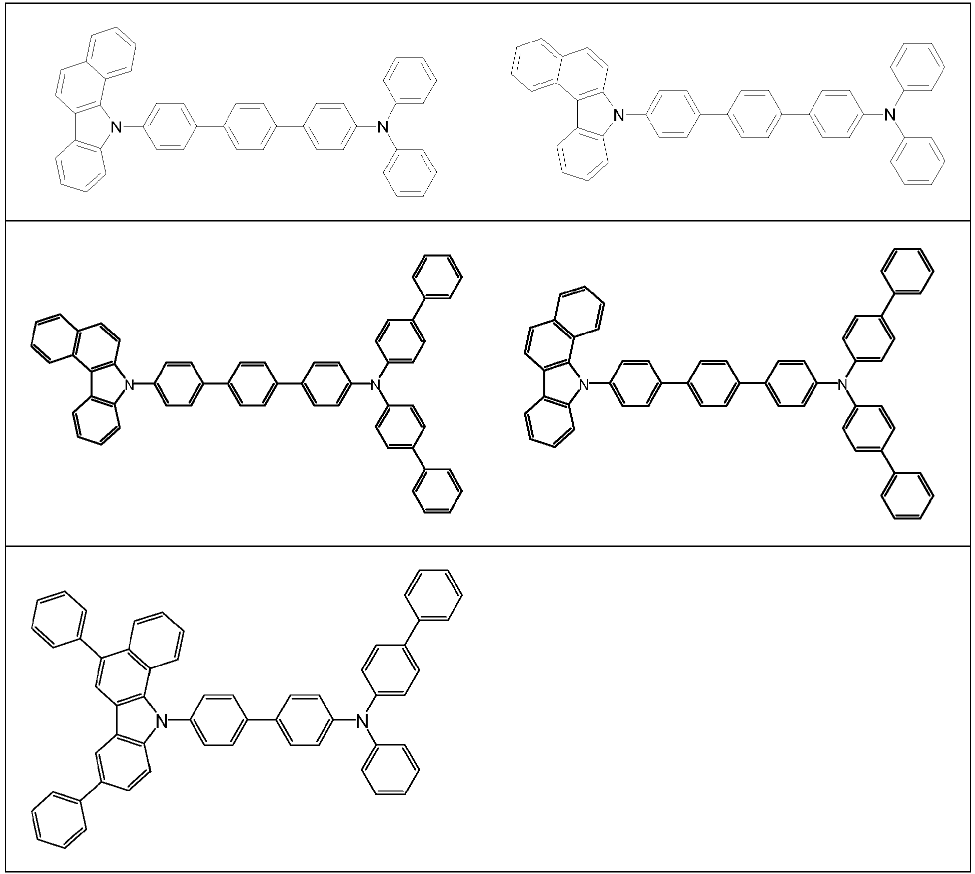

6. The organic light emitting diode of claim 1, wherein the compound represented by Formula 2 is selected from the group consisting of the following Structural Formulas:

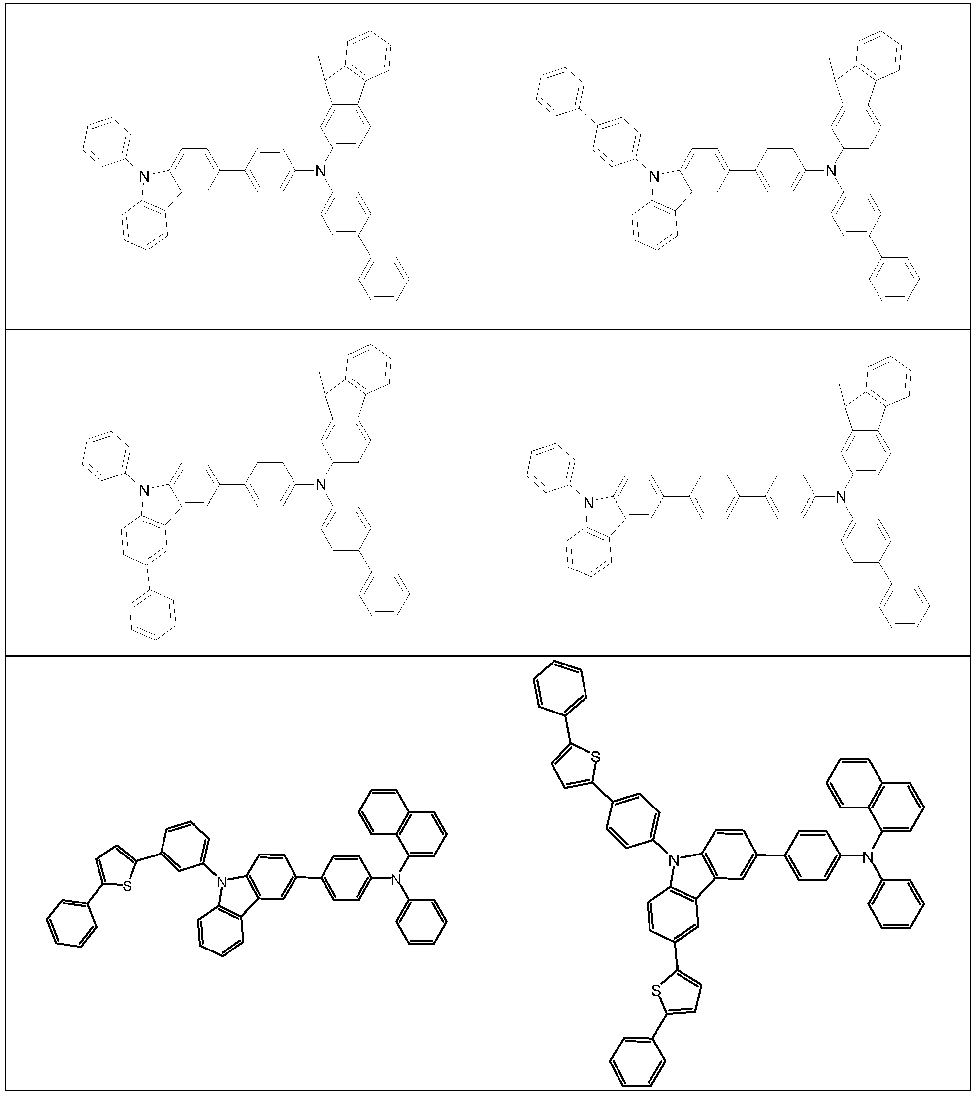

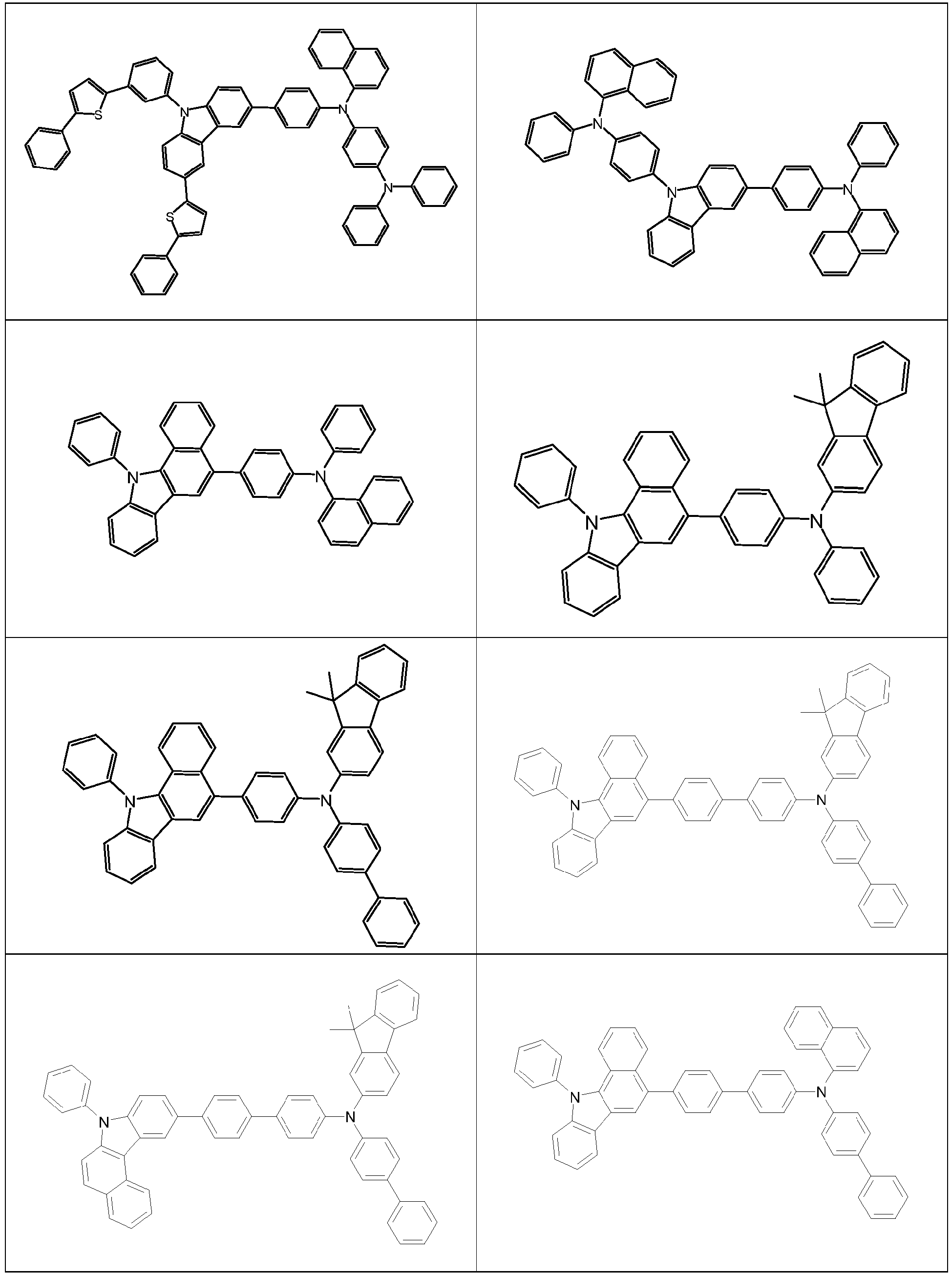

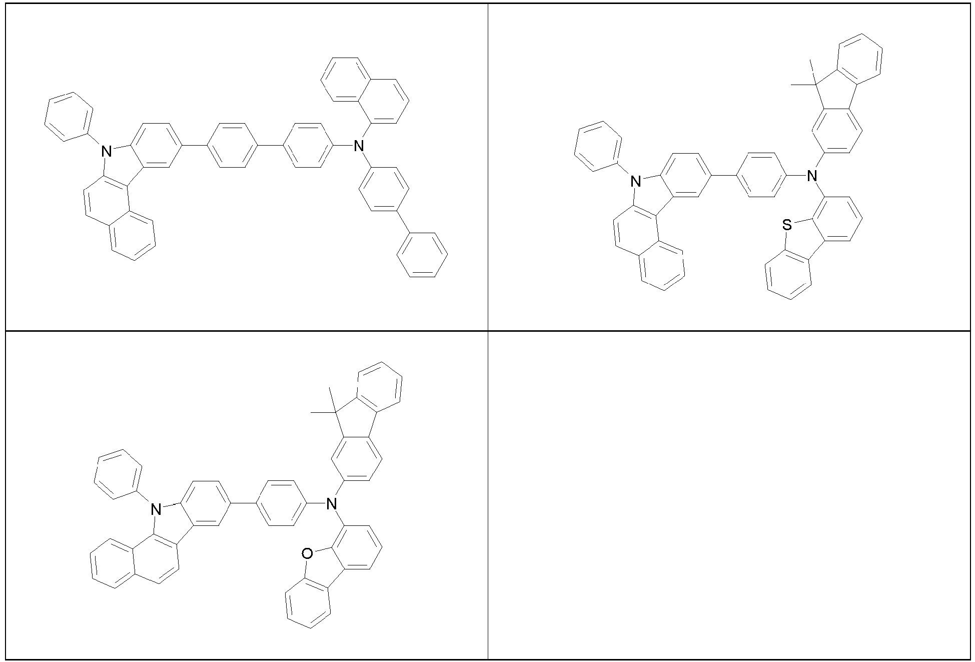

## Patentansprüche

1. Organische Leuchtdiode, umfassend eine Anode (2), eine Kathode (4) und eine oder mehrere organische Materialschichten zwischen der Anode und der Kathode,
wobei die organische Materialschicht eine lichtemittierende Schicht (7) umfasst,
**dadurch gekennzeichnet, dass** die organische Materialschicht, die eine durch irgendeine der folgenden Formeln 4 und 5 dargestellte Verbindung umfasst, und die organische Materialschicht, die eine durch die folgende Formel 2 dargestellte Verbindung umfasst, zwischen der Anode und der lichtemittierenden Schicht (7) umfasst sind,
die organische Materialschicht, die eine durch Formel 2 dargestellte Verbindung umfasst, eine Lochtransportschicht (6) ist und
die organische Materialschicht, die eine durch irgendeine der folgenden Formeln 4 und 5 dargestellte Verbindung umfasst, eine Elektronenblockierschicht ist: 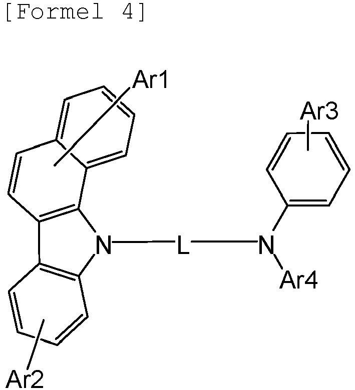 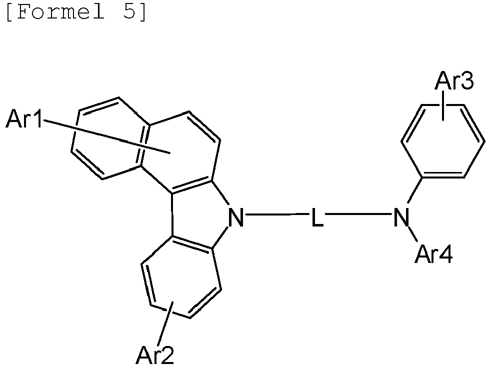 wobei in den Formeln 4 und 5
Ar1 bis Ar2 gleich oder verschieden voneinander und jeweils unabhängig aus der Gruppe, bestehend aus Wasserstoff, einer substituierten oder unsubstituierten Arylgruppe mit 6 bis 30 Kohlenstoffatomen und einer substituierten oder unsubstituierten Heteroarylgruppe mit 5 bis 30 Kohlenstoffatomen, ausgewählt sind,
Ar3 aus der Gruppe, bestehend aus Wasserstoff, unsubstituierter Phenylgruppe und unsubstituierter Biphenylgruppe, ausgewählt ist,
Ar4 aus der Gruppe, bestehend aus einer substituierten oder unsubstituierten Phenylgruppe, einer substituierten oder unsubstituierten Biphenylgruppe, einer substituierten oder unsubstituierten Terphenylgruppe, einer substituierten oder unsubstituierten Triphenylgruppe, einer substituierten oder unsubstituierten Dibenzothiophengruppe und einer substituierten oder unsubstituierten Dibenzofurangruppe, ausgewählt ist,
L eine substituierte oder unsubstituierte Arylengruppe mit 6 bis 30 Kohlenstoffatomen ist, 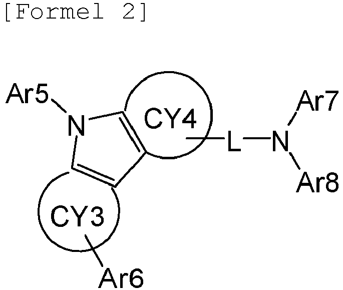
wobei in Formel 2
CY3 bis CY4 gleich oder verschieden voneinander sind und jeweils unabhängig einen Benzolzyklus oder einen Naphthalinzyklus darstellen,
Ar5 bis Ar6 gleich oder verschieden voneinander sind und jeweils unabhängig aus der Gruppe, bestehend aus Wasserstoff, einer substituierten oder unsubstituierten Arylgruppe mit 6 bis 30 Kohlenstoffatomen und einer substituierten oder unsubstituierten Heteroarylgruppe mit 5 bis 30 Kohlenstoffatomen, ausgewählt sind,
Ar7 bis Ar8 gleich oder verschieden voneinander und jeweils unabhängig aus der Gruppe, bestehend aus Wasserstoff, einer substituierten oder unsubstituierten Arylgruppe mit 6 bis 30 Kohlenstoffatomen, unsubstituierter Dibenzothiophengruppe und unsubstituierter Dibenzofurangruppe, ausgewählt sind,
mindestens eines von Ar7 und Ar8 eine substituierte oder unsubstituierte Fluorengruppe oder eine substituierte oder unsubstituierte Naphthylgruppe ist und
L eine substituierte oder unsubstituierte Arylengruppe mit 6 bis 30 Kohlenstoffatomen ist.

2. Organische Leuchtdiode gemäß Anspruch 1, worin die Elektronenblockierschicht eine organische Materialschicht ist, die mit der lichtemittierenden Schicht in Kontakt steht.

3. Organische Leuchtdiode gemäß Anspruch 1, worin Ar3 Wasserstoff oder eine Phenylgruppe ist und Ar4 eine Phenylgruppe oder eine Biphenylgruppe ist.

4. Organische Leuchtdiode gemäß Anspruch 1, worin L eine Biphenylengruppe ist.

5. Organische Leuchtdiode gemäß Anspruch 1, worin die durch irgendeine der folgenden Formeln 4 und 5 dargestellte Verbindung aus der Gruppe, bestehend aus den folgenden Strukturformeln, ausgewählt ist:

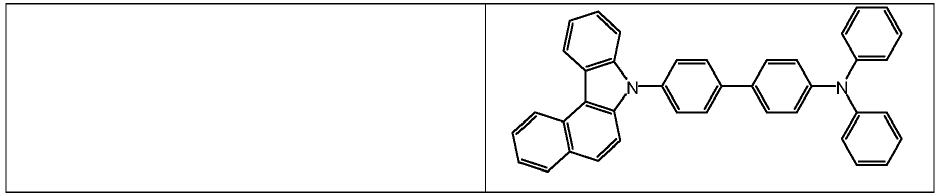

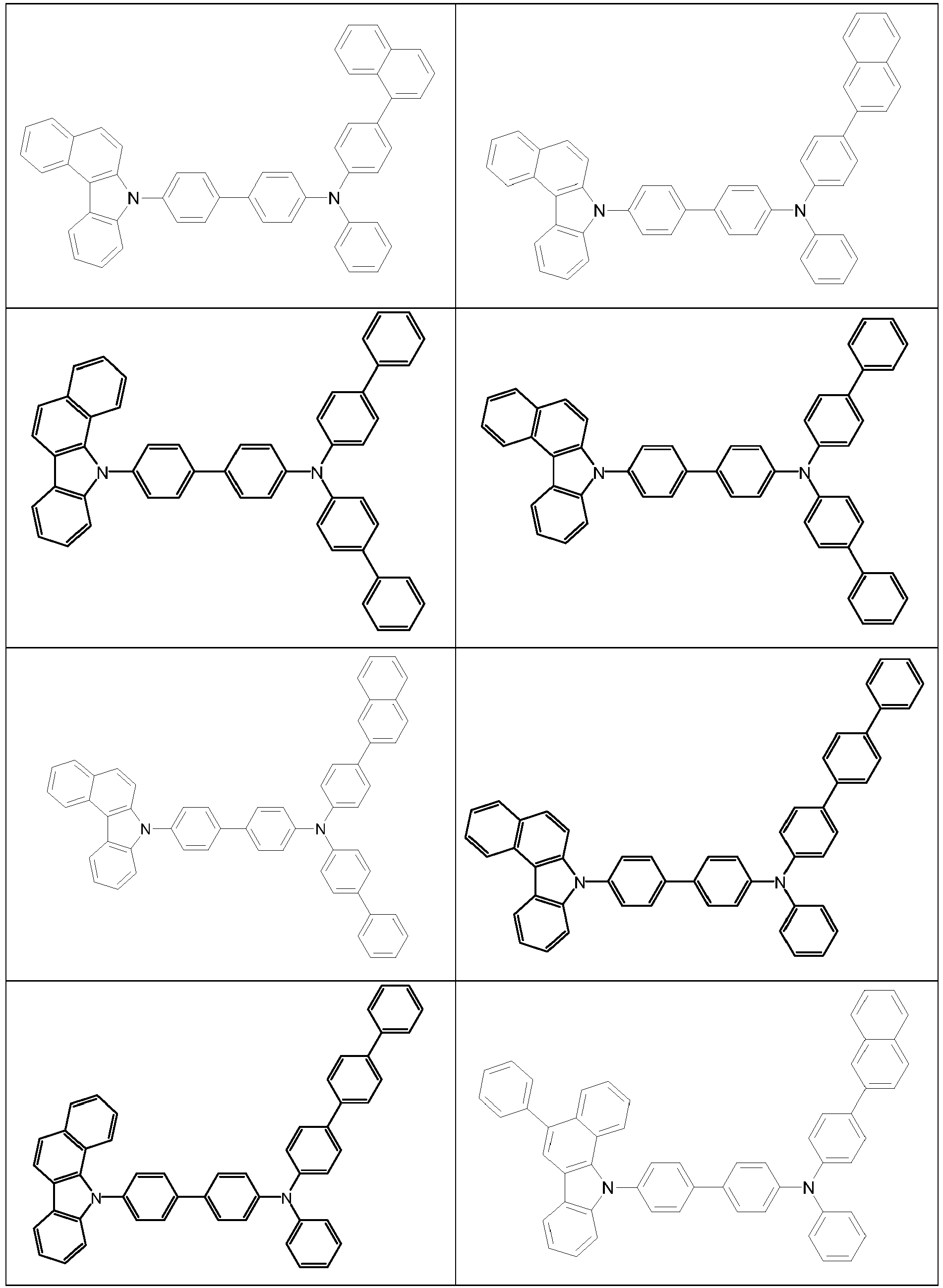

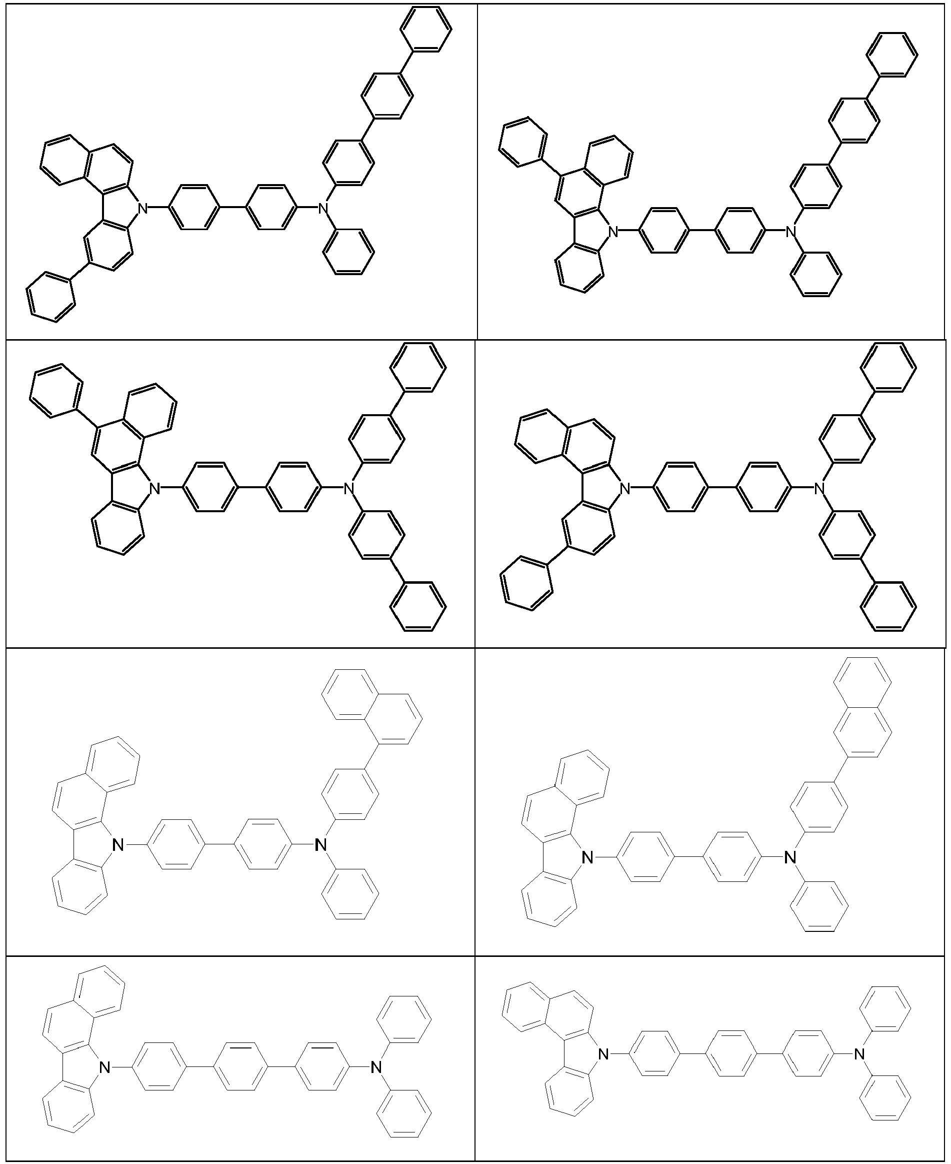

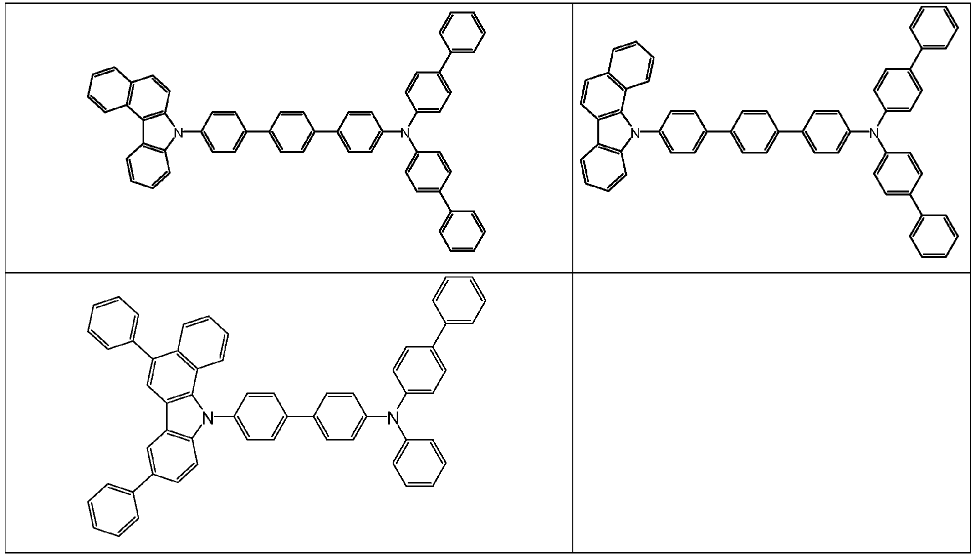

6. Organische Leuchtdiode gemäß Anspruch 1, worin die durch Formel 2 dargestellte Verbindung aus der Gruppe, bestehend aus den folgenden Strukturformeln, ausgewählt ist:

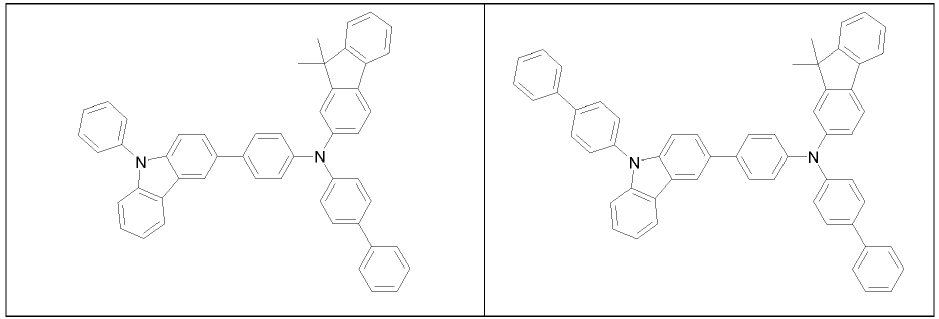

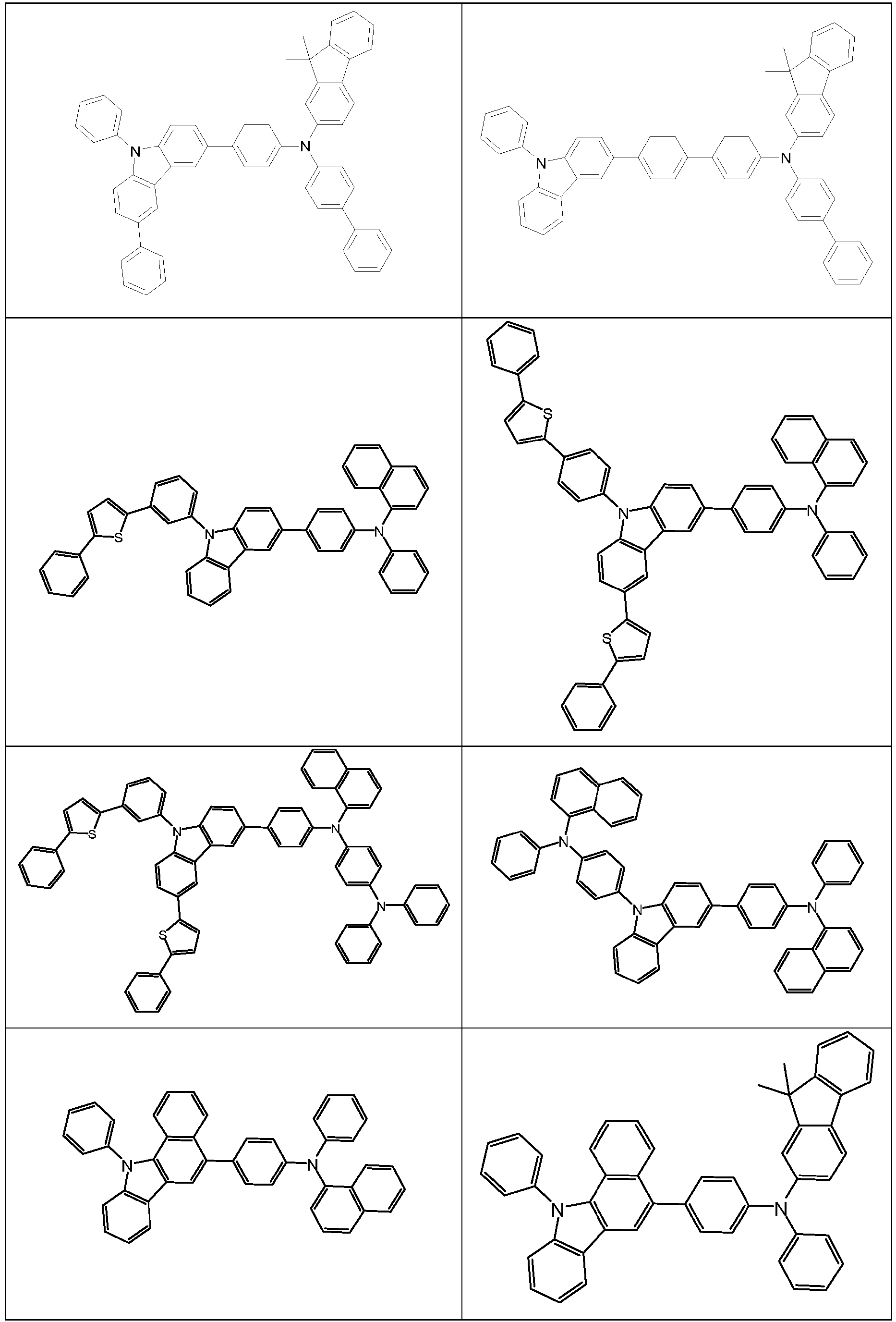

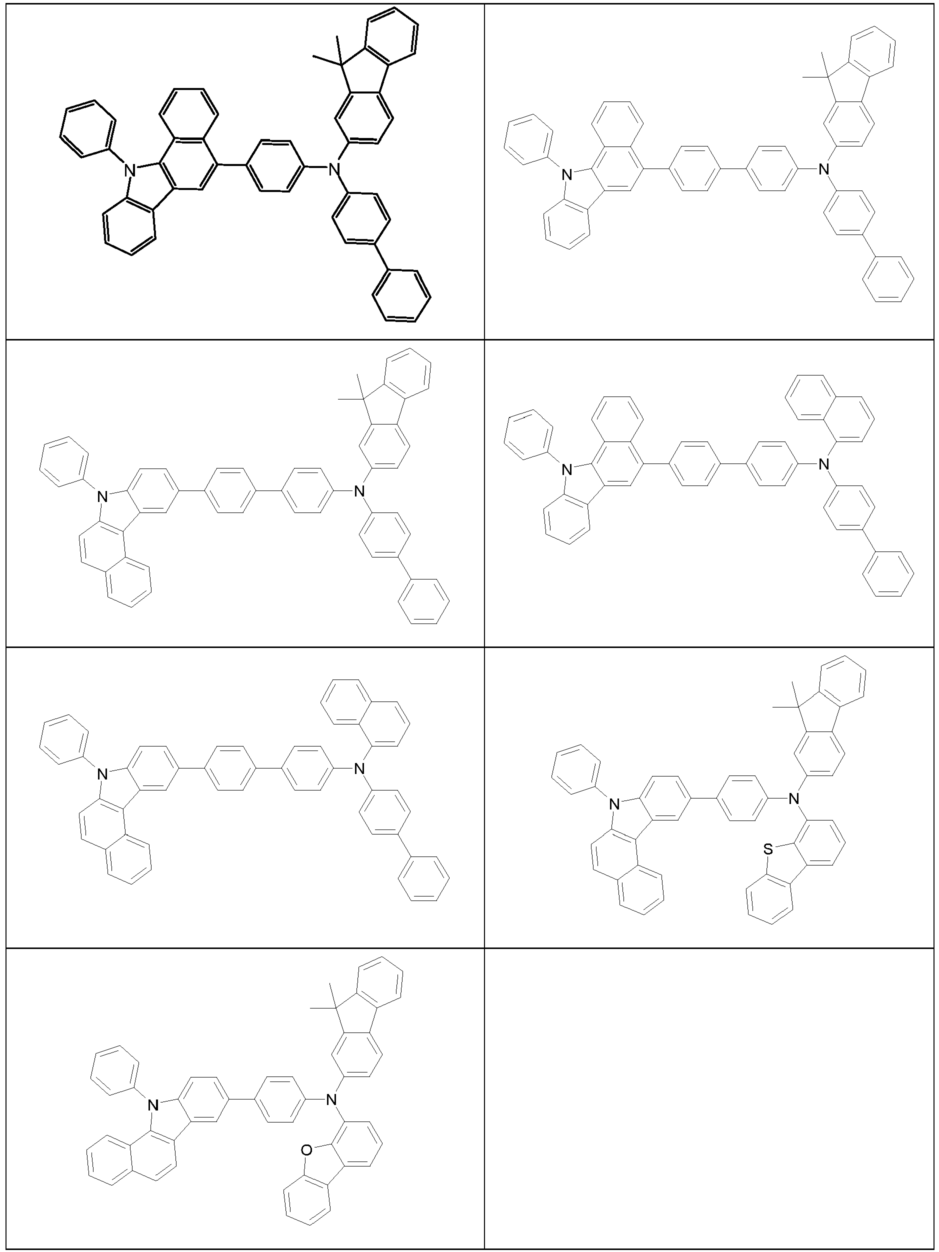

## Revendications

1. Diode électroluminescente organique comprenant une anode (2), une cathode (4) et une ou plusieurs couches de matériau organique intercalées entre l'anode et la cathode,
dans laquelle la couche de matériau organique comprend une couche électroluminescente (7),
**caractérisée en ce que** la couche de matériau organique comprenant un composé représenté par l'une quelconque des formules 4 et 5 suivantes et la couche de matériau organique comprenant un composé représenté par la formule 2 suivante sont comprises entre l'anode et la couche électroluminescente (7),
la couche de matériau organique comprenant un composé représenté par la formule 2 est une couche de transport de trous (6), et
la couche de matériau organique comprenant un composé représenté par l'une quelconque des formules 4 et 5 suivantes est une couche de blocage d'électrons : 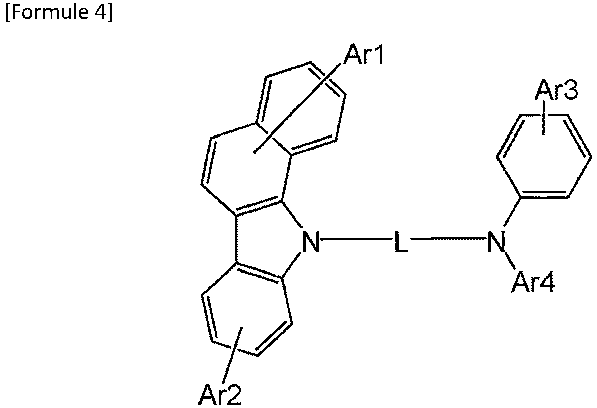 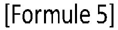 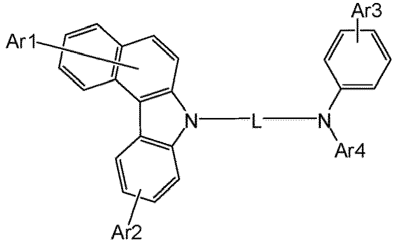 dans laquelle dans les formules 4 et 5 :
Ar1 à Ar2 sont identiques ou différents l'un de l'autre, et chacun indépendamment choisis dans le groupe constitué d'hydrogène; d'un groupe aryle substitué ou non substitué présentant 6 à 30 atomes de carbone ; et d'un groupe hétéroaryle substitué ou non substitué présentant 5 à 30 atomes de carbone,
Ar3 est choisi dans le groupe constitué d'hydrogène ; d'un groupe phényle non substitué et d'un groupe biphényle non substitué,
Ar4 est choisi dans le groupe constitué d'un groupe phényle substitué ou non substitué, d'un groupe biphényle substitué ou non substitué, d'un groupe terphényle substitué ou non substitué, d'un groupe triphényle substitué ou non substitué, d'un groupe dibenzothiophène substitué ou non substitué et d'un groupe dibenzofurane substitué ou non substitué,
L est un groupe arylène substitué ou non substitué présentant 6 à 30 atomes de carbone ; 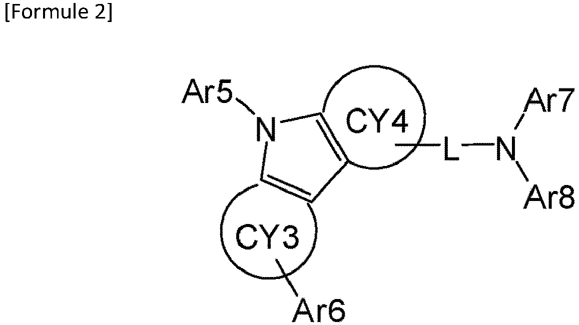
dans laquelle dans la formule 2 :
CY3 à CY4 sont identiques ou différents l'un de l'autre, et chacun représente indépendamment un cycle benzénique ou un cycle naphtalénique,
Ar5 à Ar6 sont identiques ou différents l'un de l'autre, et chacun indépendamment choisis dans le groupe constitué d'hydrogène; d'un groupe aryle substitué ou non substitué présentant 6 à 30 atomes de carbone ; et d'un groupe hétéroaryle substitué ou non substitué présentant 5 à 30 atomes de carbone,
Ar7 à Ar8 sont identiques ou différents l'un de l'autre, et chacun indépendamment choisis dans le groupe constitué d'hydrogène; d'un groupe aryle substitué ou non substitué présentant 6 à 30 atomes de carbone; d'un groupe dibenzothiophène non substitué et d'un groupe dibenzofurane non substitué,
au moins un de Ar7 et Ar8 est un groupe fluorène substitué ou non substitué ou un groupe naphtyle substitué ou non substitué, et
L est un groupe arylène substitué ou non substitué présentant 6 à 30 atomes de carbone

2. Diode électroluminescente organique selon la revendication 1, dans laquelle la couche de blocage d'électrons est une couche de matériau organique qui est en contact avec la couche électroluminescente.

3. Diode électroluminescente organique selon la revendication 1, dans laquelle Ar3 est de l'hydrogène ou un groupe phényle, et Ar4 est un groupe phényle ou un groupe biphényle.

4. Diode électroluminescente organique selon la revendication 1, dans laquelle L est un groupe biphénylène.

5. Diode électroluminescente organique selon la revendication 1, dans laquelle le composé représenté par l'une quelconque des formules 4 et 5 suivantes est choisi dans le groupe constitué des formules structurales suivantes :

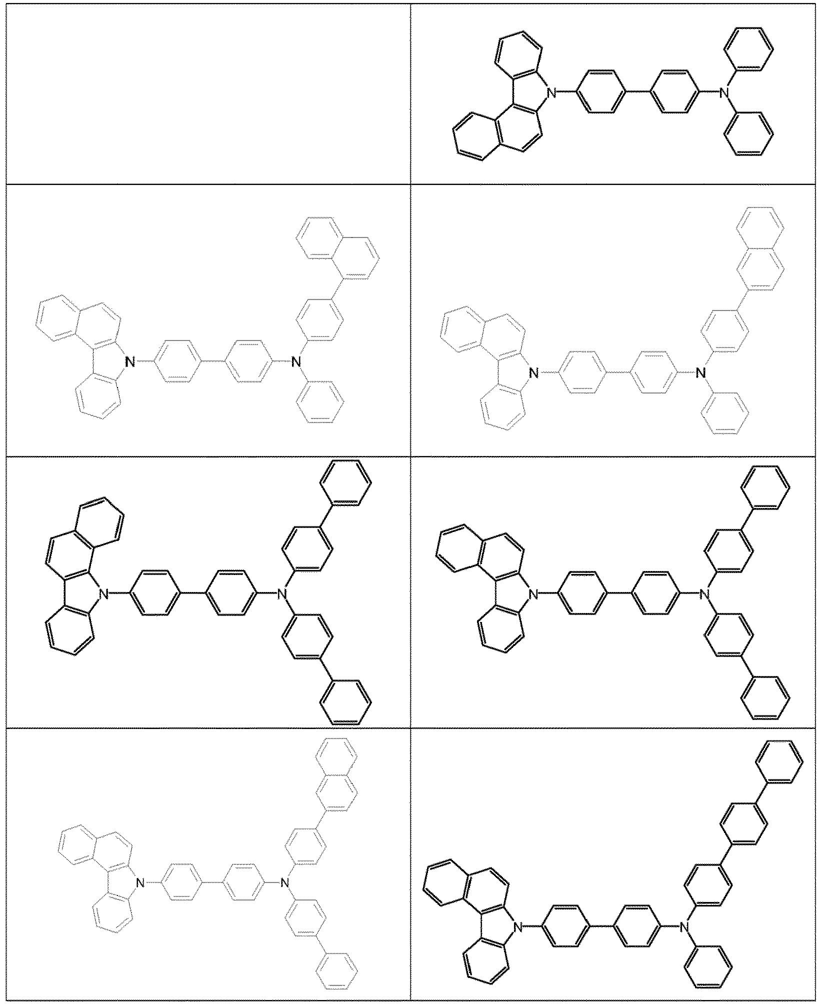

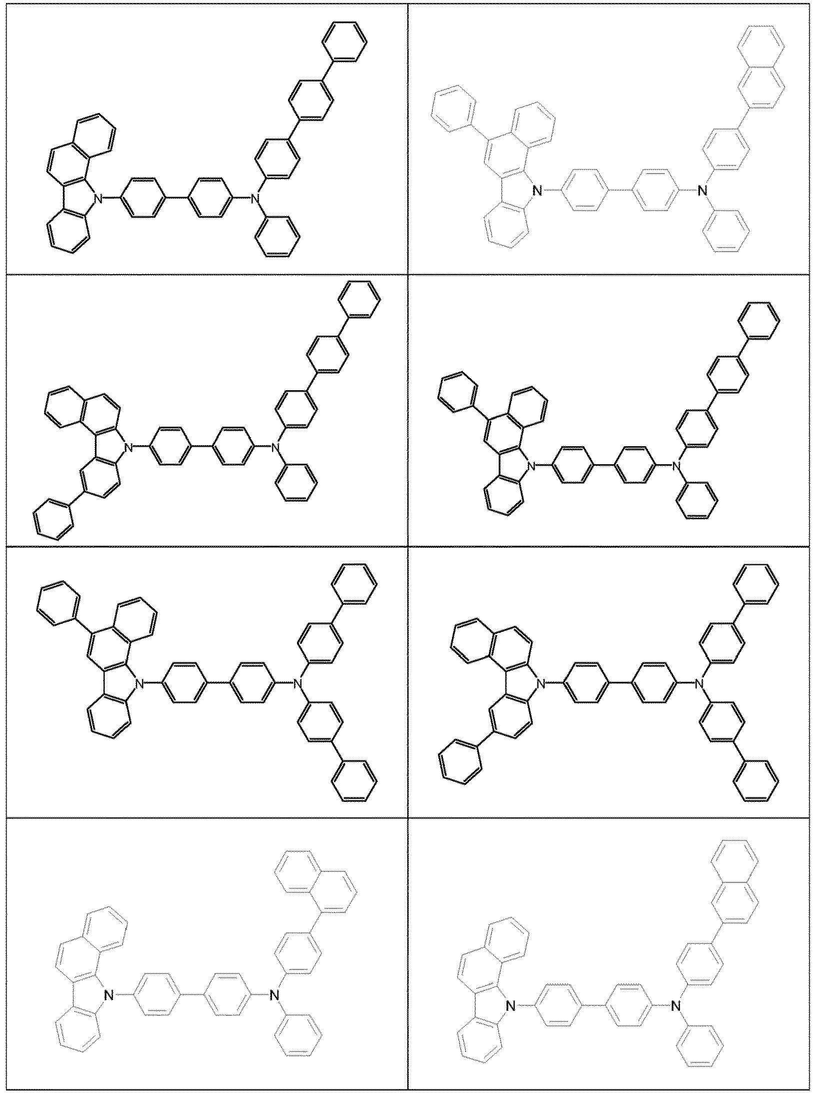

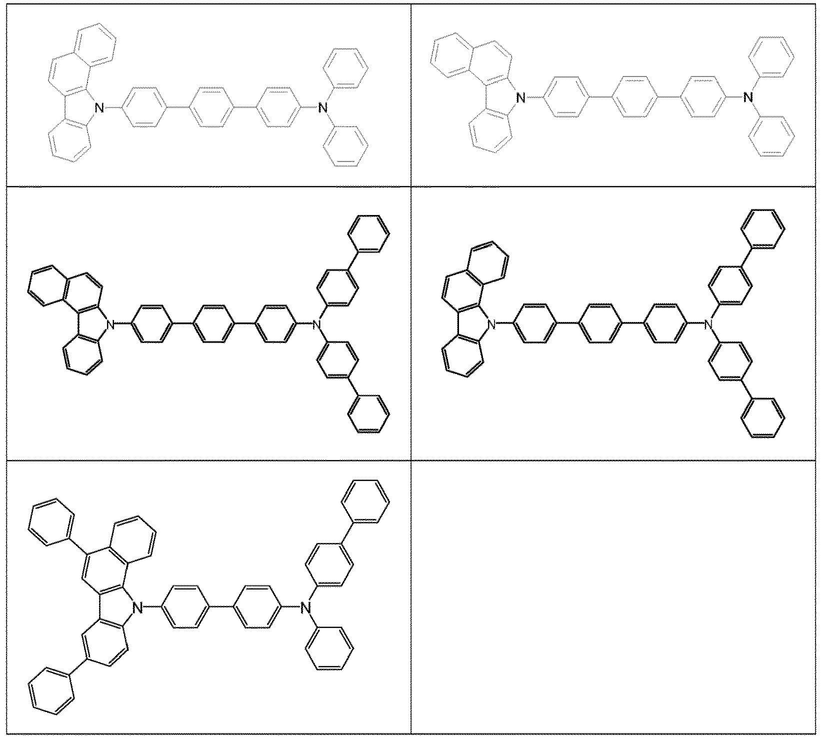

6. Diode électroluminescente organique selon la revendication 1, dans laquelle le composé représenté par la formule 2 est choisi dans le groupe constitué des formules structurales suivantes :
